(19) Europäisches Patentamt
European Patent Office
Office européen des brevets

(11) EP 1 245 642 B1

(12) **EUROPEAN PATENT SPECIFICATION**

(45) Date of publication and mention of the grant of the patent:
**08.06.2005 Bulletin 2005/23**

(51) Int Cl.⁷: **C08L 83/04**, C08J 9/26, H01B 3/46, H01L 21/316, H01L 21/312

(21) Application number: **02251958.1**

(22) Date of filing: **19.03.2002**

(54) **Siloxane-based resin and method for forming an insulating film between interconnecting layers in wafers**

Polysiloxanharz und Verfahren zur Herstellung einer Zwischenschicht daraus für Wafer

Résine de polysiloxane et méthode de la production d' une couche intermédiaire pour plaquettes

(84) Designated Contracting States:
**DE FI FR GB SE**

(30) Priority: **27.03.2001 KR 2001015884**
**14.09.2001 KR 2001056798**

(43) Date of publication of application:
**02.10.2002 Bulletin 2002/40**

(73) Proprietor: **Samsung Electronics Co., Ltd.**
**Suwon-Shi, Kyungki-Do 442-742 (KR)**

(72) Inventors:
- **Lyu, Yi Yeol**
  **Yusung-Gu, Daejun-Shi, 305-761 (KR)**
- **Yim, Jin Heong**
  **Yusung-Gu, Daejun-Shi, 305-390 (KR)**
- **Jeong, Hyun Dam,**
  **111/802 Evergreen Byucksan Apt.**
  **Suwon-Shi, Kyungki-Do, 442-707 (KR)**
- **Kim, Jung Hyung, 6/202 Joint Control Apartment**
  **Daejun-Shi, 305-340 (KR)**
- **Mah, Sang Kook**
  **Yongdungpo-Gu, Seoul, 150-762 (KR)**
- **Nah, Eun Ju**
  **Chung-Gu, Daejun-Shi, 301-150 (KR)**
- **Hwang, Sun Il**
  **Chung-Gu, Daejun-Shi 301-142 (KR)**

(74) Representative: **Kyle, Diana**
**Elkington and Fife LLP,**
**Prospect House**
**8 Pembroke Road**
**Sevenoaks, Kent TN13 1XR (GB)**

(56) References cited:
**EP-A- 0 727 817**
**EP-A- 0 750 337**
**US-A- 5 484 867**
**US-A- 5 942 638**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 245 642 B1

Printed by Jouve, 75001 PARIS (FR)

## Description

The present invention relates to a siloxane-based resin and a method for forming insulating film between interconnect layers in semiconductor devices by using the same. More specifically, the present invention relates to a siloxane-based resin prepared by hydrolyzing and polycondensing cyclic and/or cage-shape siloxane compounds, optionally with at least one silane compound, in an organic solvent in the presence of a catalyst and water. The present invention also relates to a method for forming insulating film between interconnect layers in semiconductor devices, wherein the siloxane-based resin described above is used as low dielectric insulating materials.

## BACKGROUND OF THE INVENTION

As the circuit density in multilevel integrated circuit devices increases, the reduction of feature size in a semiconductor device is strongly required. But, there are fatal problems such as R(resistance) x C(capacitance) delay due to crosstalk between interconnect lines. Therefore, dielectric constant of interlayer insulating films should be lowered so as to decrease the RC delay as much as possible. For this purpose, there have been various attempts to develop low dielectric materials for use in the insulating film.

For example, polysilsesquioxanes having dielectric constant of approximately 2.5~3.1 has replaced $SiO_2$ having dielectric constant of 4.0 in chemical vapor deposition(CVD). Such polysilsesquioxanes can be also applied to a spin coating method due to its excellent planation property.

The polysilsesquioxanes as well as preparing methods thereof are well known in the art. For example, US Patent No. 3,615,272 discloses a method for preparing completely condensed soluble hydrogensilsesquioxane resins, which comprises the steps of condensing trichlorosilanes in a sulfuric acid medium, and then washing the resulting resins with water or aqueous sulfuric acid. US Patent No. 5,010,159 discloses a method for synthesizing soluble condensed hydridosilicon resins, which comprises the steps of hydrolyzing hydridosilanes in an arylsulfuric acid hydrate-containing hydrolysis medium, and then contacting the resulting resins with a neutralizing agent. US Patent No. 6,232,424 describes a highly soluble silicone resin composition having excellent solution stability, which was prepared by hydrolyzing and polycondensing tetraalkoxysilane, organosilane and organotrialkoxysilane monomers in the presence of water and a catalyst. US Patent No. 6,000,339 teaches that a silica-based compound, which may be useful for improving the resistance and physical properties as well as thickness of a coating film, can be obtained from a reaction of a monomer selected from the group consisting of alkoxysilane, fluorine-containing alkoxysilane and alkylalkoxysilane and a titanium- or zirconium-alkoxide compound in the presence of water and a catalyst. US Patent No. 5,853,808 describes that silsesquioxane polymers that are useful for preparing $SiO_2$-rich ceramic coatings can be obtained as the polymeric reaction products from the hydrolysis and condensation of organosilanes having a β-substituted alkyl group.

However, the prior polysilsesquioxane resins have not accomplished very low dielectric constant that is currently required for insulating film between interconnect layers in semiconductor devices. Additionally, they have been required to improve in mechanical properties, thermal stability, crack-resistance, and so on.

## SUMMARY OF THE INVENTION

A feature of the present invention is a method for forming low dielectric insulating film between interconnect layers in semiconductor devices by using a siloxane-based resin having very low dielectric constant, wherein the resin is obtained from the copolymerization of cyclic and/or cage-shape siloxane compounds optionally with one or more silane compounds.

An aspect of the present invention relates to siloxane-based resins that are prepared by hydrolyzing and polycondensing a cyclic siloxane compound of formula (1) and a cage-shape siloxane compound of any of formulas (2a)-(2c) in an organic solvent in the presence of a catalyst and water:

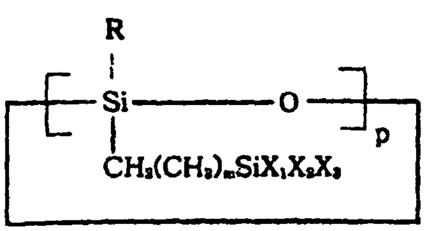

(1)

wherein,

R is H, $C_{1-3}$ alkyl, $C_{3-10}$ cycloalkyl, or $C_{6-15}$ aryl;

each of $X_1$, $X_2$, and $X_3$ is, independently, $C_{1-3}$ alkyl, $C_{1-10}$ alkoxy, or halo, provided that at least one is alkoxy or halo;

p is an integer from 3 to 8; and

m is an integer from 1 to 10;

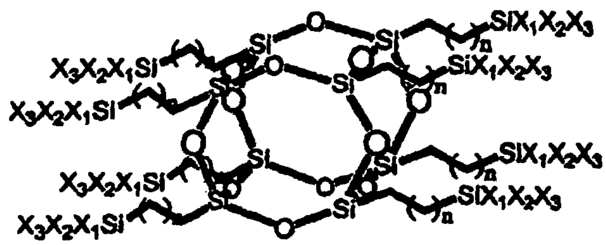

(2a)

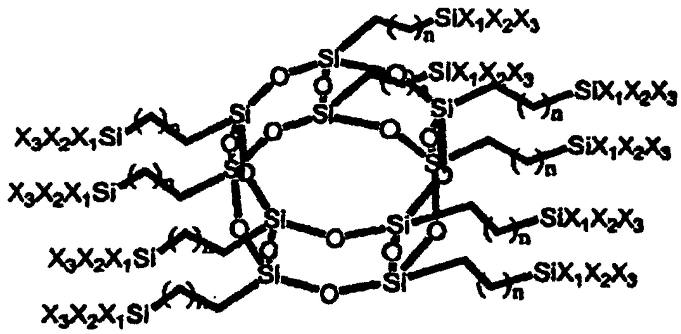

(2b)

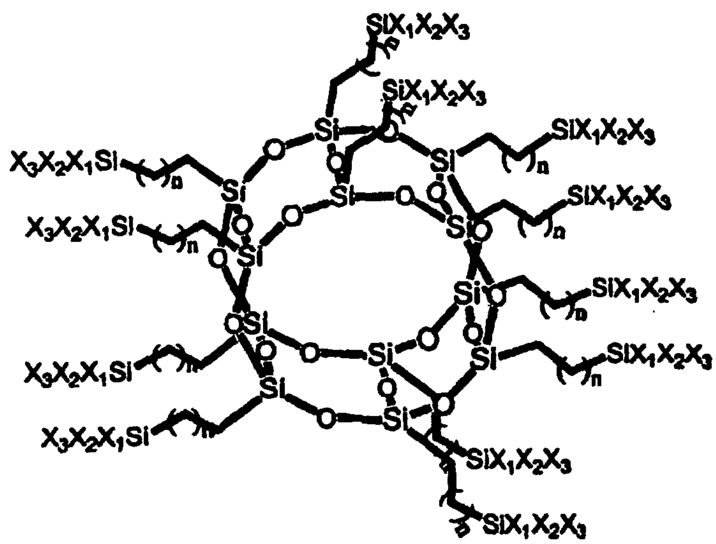

(2c)

in the above formulas (2a)-(2c),

each of $X_1$, $X_2$, and $X_3$ is, independently, $C_{1-3}$ alkyl, $C_{1-10}$ alkoxy, or halo, provided that at least one is alkoxy or halo; and

n is an integer from 1 to 12.

Another aspect of the present invention relates to siloxane-based resins that are prepared by hydrolyzing and polycondensing a cyclic siloxane compound of formula (1) and a cage-shape siloxane compound of any of formulas (2a)-(2c), together with a silane compound of formula (3) and/or a silane compound of formula (4), in an organic solvent in the presence of a catalyst and water:

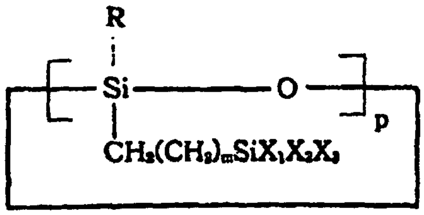

(1)

wherein,

R is H, $C_{1-3}$ alkyl, $C_{3-10}$ cycloalkyl, or $C_{6-15}$ aryl;

each of $X_1$, $X_2$, and $X_3$ is, independently, $C_{1-3}$ alkyl, $C_{1-10}$ alkoxy, or halo, provided that at least one is alkoxy or halo;

p is an integer from 3 to 8; and

m is an integer from 1 to 10;

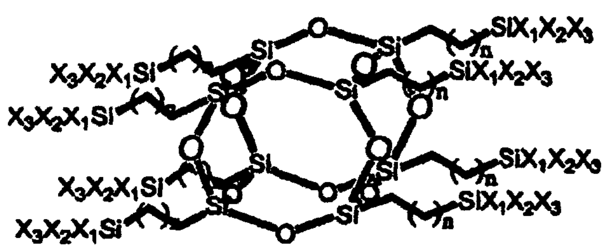

(2a)

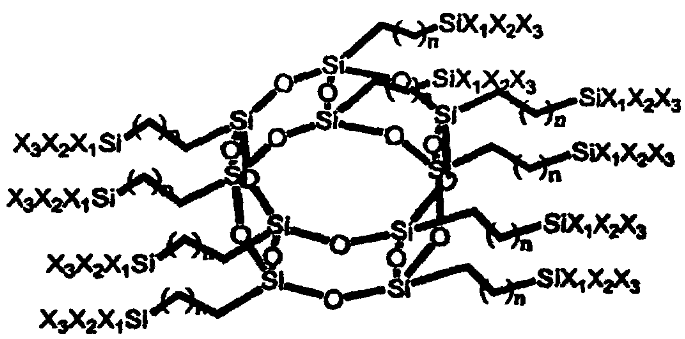

(2b)

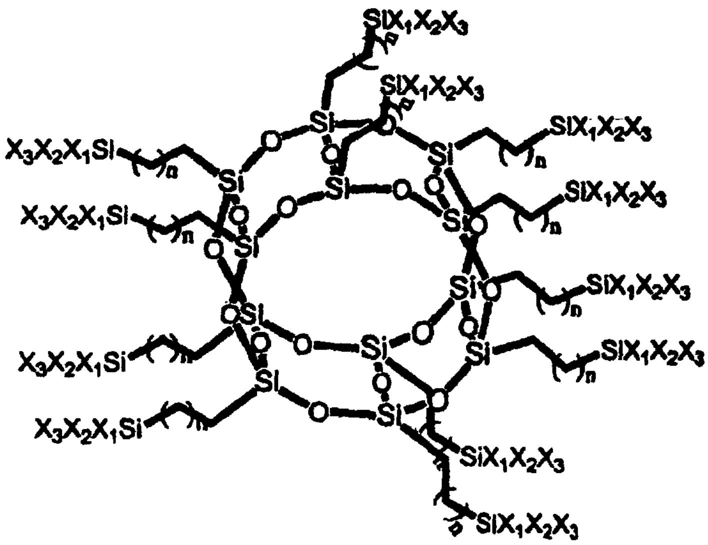

(2c)

in the above formulas 2(a)-2(c),

each of $X_1$, $X_2$, and $X_3$ is, independently, $C_{1-3}$ alkyl, $C_{1-10}$ alkoxy, or halo, provided that at least one is alkoxy or halo; and

n is an integer from 1 to 12;

$$SiX_1X_2X_3X_4 \quad (3)$$

wherein,

each of $X_1$, $X_2$, $X_3$, and $X_4$ is, independently, $C_{1-10}$ alkoxy, or halo;

$$RSiX_1X_2X_3 \quad (4)$$

wherein,

R is H, $C_{1-3}$ alkyl, $C_{3-10}$ cycloalkyl, or $C_{6-15}$ aryl; and

each of $X_1$, $X_2$, and $X_3$ is, independently, $C_{1-3}$ alkyl, $C_{1-10}$ alkoxy, or halo, provided that at least one is alkoxy or halo.

Still another aspect of the present invention relates to siloxane-based resins that are prepared by hydrolyzing and polycondensing a cyclic siloxane compound of formula (1), together with a silane compound of formula (3) and/or a silane compound of formula (4), in an organic solvent in the presence of a catalyst and water:

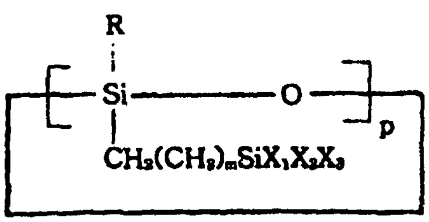

(1)

wherein,

R is H, $C_{1-3}$ alkyl, $C_{3-10}$ cycloalkyl, or $C_{6-15}$ aryl;

each of $X_1$, $X_2$, and $X_3$ is, independently, $C_{1-3}$ alkyl, $C_{1-10}$ alkoxy, or halo, provided that at least one is alkoxy or halo;

p is an integer from 3 to 8; and

m is an integer from 1 to 10;

$$SiX_1X_2X_3X_4 \quad (3)$$

wherein,
each of $X_1$, $X_2$, $X_3$, and $X_4$ is, independently, $C_{1-10}$ alkoxy, or halo;

$$RSiX_1X_2X_3 \quad (4)$$

wherein,
R is H, $C_{1-3}$ alkyl, $C_{3-10}$ cycloalkyl, or $C_{6-15}$ aryl; and
each of $X_1$, $X_2$, and $X_3$ is, independently, $C_{1-3}$ alkyl, $C_{1-10}$ alkoxy, or halo, provided that at least one is alkoxy or halo.

Still another aspect of the present invention relates to siloxane-based resins that are prepared by hydrolyzing and polycondensing a cage-shape siloxane compound of any of formulas (2a)-(2c), together with a silane compound of formula (3) and/or a silane compound of formula (4), in an organic solvent in the presence of a catalyst and water:

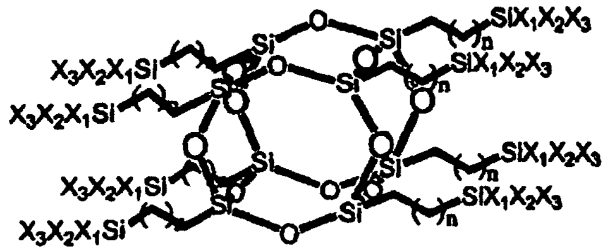

(2a)

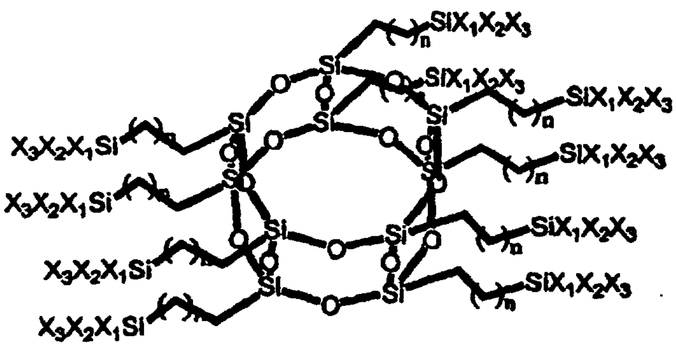

(2b)

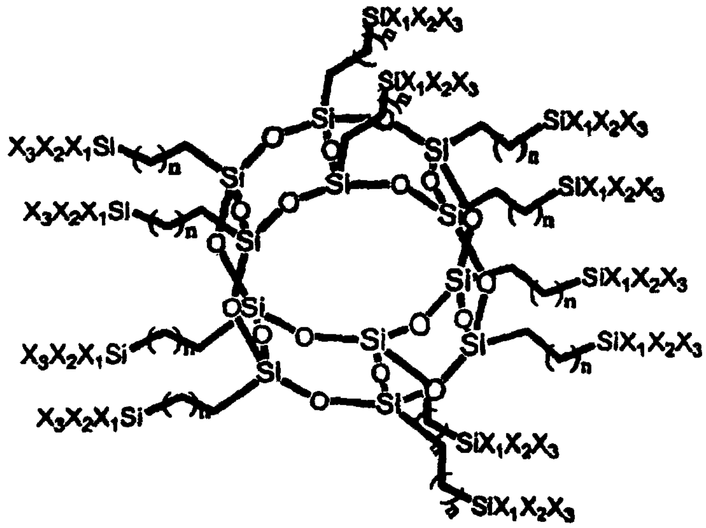

(2c)

in the above formulas (2a)-(2c),

each of $X_1$, $X_2$, and $X_3$ is, independently, $C_{1-3}$ alkyl, $C_{1-10}$ alkoxy, or halo, provided that at least one is alkoxy or halo; and

n is an integer from 1 to 12;

$$SiX_1X_2X_3X_4 \quad (3)$$

wherein,

each of $X_1$, $X_2$, $X_3$, and $X_4$ is, independently, $C_{1-10}$ alkoxy, or halo;

$$RSiX_1X_2X_3 \quad (4)$$

wherein,

R is H, $C_{1-3}$ alkyl, $C_{3-10}$ cycloalkyl, or $C_{6-15}$ aryl; and

each of $X_1$, $X_2$, and $X_3$ is, independently, $C_{1-3}$ alkyl, $C_{1-10}$ alkoxy, or halo, provided that at least one is alkoxy or halo.

Still another aspect of the present invention relates to a method for forming insulating film between interconnect layers in semiconductor devices, the method comprising the steps of: providing a resinous solution by dissolving the siloxane-based resin described above in an organic solvent; coating a silicon wafer with the resinous solution; and heat-curing the resulting coating film.

All of the above features and other features of the present invention will be successfully achieved from the present invention described in the following.

## DETAILED DESCRIPTION OF THE INVENTION

A siloxane-based resin of the present invention is prepared by hydrolyzing and polycondensing cyclic and/or cage-shape siloxane monomers, optionally with at least one silane monomer, in an organic solvent in the presence of a catalyst and water.

The cyclic siloxane monomers used in the present invention can be represented by the following formula (1):

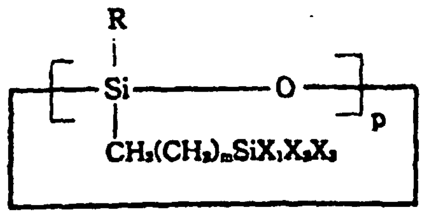

(1)

wherein,

R is H, $C_{1-3}$ alkyl, $C_{3-10}$ cycloalkyl, or $C_{6-15}$ aryl;

each of $X_1$, $X_2$, and $X_3$ is, independently, $C_{1-3}$ alkyl, $C_{1-10}$ alkoxy, or halo, provided that at least one is alkoxy or halo;

p is an integer from 3 to 8; and

m is an integer from 1 to 10.

As can be seen from the above formula (1), two silicon atoms are linked to each other through an oxygen atom to form cyclic structure, and the terminal of each branch comprises at least one hydrolysable group. These cyclic siloxane monomers, for example, may be obtained from a hydrosililation reaction using a metal catalyst.

The cage-shape siloxane monomers used in the present invention can be represented by one of the following formulas (2a)-(2c):

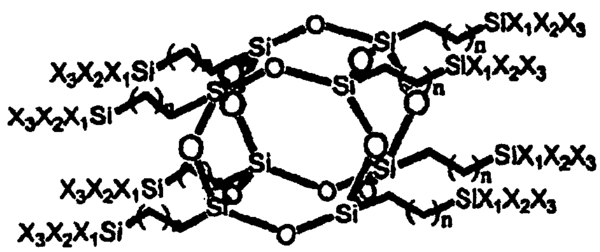

(2a)

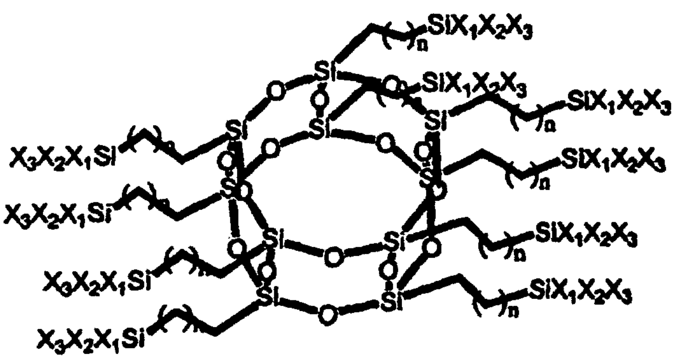

(2b)

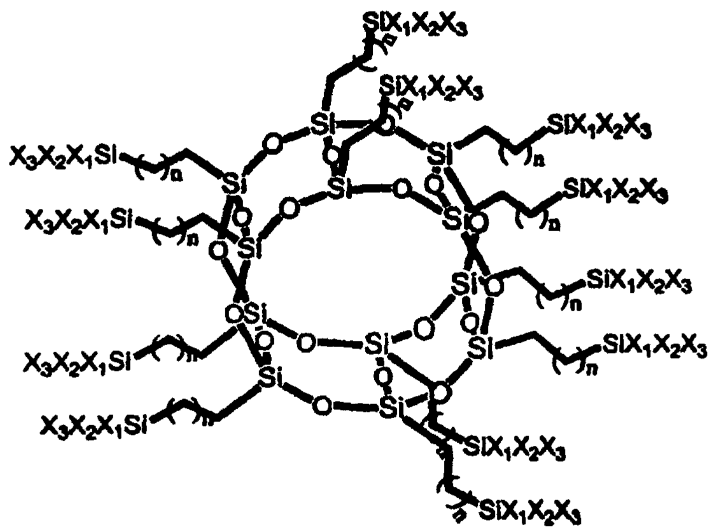

(2c)

in the above formulas (2a)-(2c),

each of $X_1$, $X_2$, and $X_3$ is, independently, $C_{1-3}$ alkyl, $C_{1-10}$ alkoxy, or halo, provided that at least one is alkoxy or halo; and

n is an integer from 1 to 12.

As can be seen from the above formulas (2a)-(2c), two silicon atoms are linked to each other through an oxygen atom to form cyclic structure, and the terminal of each branch comprises at least one hydrolysable group.

As the cage-shape siloxane monomers, commercially available ones whose terminal functional groups are halogens can be used, without modification or after substitution of the terminal halogens with alkyl and/or alkoxy groups. Such substitution may be accomplished by any of standard methods well known in the art. For example, the substitution of the terminal halogens with alkoxy groups can be readily accomplished through reacting the halogenated cage-shape siloxane compound with an alcohol and a triethylamine.

On the other hand, the silane monomers used in the present invention can be represented by the following formula (3), in which Si has four hydrolysable substituents:

$$SiX_1X_2X_3X_4 \quad (3)$$

wherein,

each of $X_1$, $X_2$, $X_3$, and $X_4$ is, independently, $C_{1-10}$ alkoxy, or halo.

Non-limiting examples of such silane monomer include tetra-n-butoxysilane, tetra-n-propoxysilane, tetraethoxysilane, tetramethoxysilane, tetrachlorosilane, tetrabromosilane, tetrafluorosilane, triethoxychlorosilane, and trimethoxychlorosilane.

Also, the other silane monomers represented by the following formula (4) can be used in the preparation of the siloxane-based resins of the present invention, in which Si has at least one hydrolysable substituent:

$$RSiX_1X_2X_3 \quad (4)$$

wherein,

R is H, $C_{1-3}$ alkyl, $C_{3-10}$ cycloalkyl, or $C_{6-15}$ aryl; and

each of $X_1$, $X_2$, and $X_3$ is, independently, $C_{1-3}$ alkyl, $C_{1-10}$ alkoxy, or halo, provided that at least one is alkoxy or halo.

Non-limiting examples of such silane monomer include methyltriethoxysilane, methyltrimethoxysilane, methyltri-n-propoxysilane, phenyltrimethoxysilane, phenyltriethoxysilane, phenyltrichlorosilane, phenyltrifluorosilane, methyltrichlorosilane, methyltribromosilane, methyltrifluorosilane, triethoxysilane, trimethoxysilane, trichlorosilane, and trifluorosilane.

The siloxane-based resins of the present invention can be obtained as copolymeric products from the hydrolysis and polycondensation of the cyclic siloxane compound of formula (1)(hereinafter, referred to as siloxane compound (1)) and the cage-shape siloxane compound of formula (2) (hereinafter, referred to as siloxane compound (2)) in an organic solvent in the presence of a catalyst and water. Alternatively, the siloxane-based resins of the present invention can be prepared by hydrolyzing and polycondensing either or both of siloxane compounds (1) and (2), together with either or both of the silane compound of formula (3)(hereinafter, referred to as silane compound (3)) and the silane compound of formula (4) (hereinafter, referred to as silane compound (4)), in an organic solvent in the presence of a catalyst and water.

For the preparation of a binary copolymer from siloxane compounds (1) and (2), the molar ratio of compound (1) vs. compound (2) is between 0.1:99.9 and 99.9:0.1, preferably 5:95 and 50:50.

On the other hand, for the preparation of a ternary copolymer from both siloxane compounds (1) and (2), in conjunction with either silane compound (3) or (4), an amount of each compound ranges from 1 to 98mol%, respectively.

Moreover, a quaternary copolymer can be prepared by using both silane compounds (3) and (4) in conjunction with both siloxane compounds (1) and (2). At this time, each of the four compounds is used in an amount of 1-97mol%, respectively.

In the present invention, as siloxane monomers, both cyclic and cage-shape siloxane compounds are not always used in combination, and thus it is also possible to use either of the cyclic and cage-shape siloxane compounds.

Where cyclic siloxane compound (1) is solely used as a siloxane monomer, silane compound (3) is preferably copolymerized therewith to provide a binary copolymer, wherein the molar ratio of compound (1) vs. compound (3) is between 99.9:0.1 and 0.1:99.9, preferably 95:5 and 50:50. Alternatively, silane compound (4) can be additionally employed in the copolymerization to provide a ternary copolymer. This ternary copolymer contains 1-98mol% of compound (1), 1-98mol% of compound (3), and 1-98mol% of compound (4).

Similarly, where cage-shape siloxane compound (2) is solely used as a siloxane monomer, silane compound (4) is preferably copolymerized therewith to provide a binary copolymer, wherein the molar ratio of compound (2) vs. compound (4) is between 0.1:99.9 and 99.9:0.1, preferably 5:95 and 50:50. Alternatively, silane compound (3) can be further added to the copolymerization reaction to provide a ternary copolymer. This ternary copolymer contains 1-98mol% of compound (2), 1-98mol% of compound (3), and 1-98mol% of compound (4).

As the organic solvents used in the preparation of the siloxane-based resins according to the present invention, aromatic hydrocarbon solvent, aliphatic hydrocarbon solvent, ketone-based solvent, ether-based solvent, acetate-based solvent, alcohol-based solvent, silicon-based solvent, or mixtures thereof are preferred.

Exemplary catalysts used in the present invention include, without limitation, hydrochloric acid, nitric acid, benzene sulfonic acid, oxalic acid, formic acid, potassium hydroxide, sodium hydroxide, triethylamine, sodium bicarbonate, pyridine, and mixtures thereof.

In the hydrolysis and polycondensation reaction according to the present invention, the molar ratio of the catalyst vs. monomers to be polymerized(inclusive of siloxane and silane compounds) is preferably between 0.00001: 1 and 10:1. Further, 0.1-1,000mol of water is added to 1mol of the monomers. Then, the hydrolysis and polycondensation are carried out at a temperature of 0-200°C, preferably 50-110°C, for 0.1-100hrs, preferably 3-48hrs.

The siloxane-based resins thus prepared have Mw of 3,000 to 500,000, preferably 3,000 to 100,000. Preferably, Si-OR content in the whole terminal groups represented by Si-OR and/or Si-R is more than 5mol%, wherein R is H, $C_{1-3}$ alkyl, $C_{3-10}$ cycloalkyl, or $C_{6-15}$ aryl. The siloxane-based resins of the present invention can be used as matrix precursors of insulating film between interconnect layers in semiconductor devices.

Particular method for forming insulating film between interconnect layers in semiconductor devices by using the siloxane-based resins according to the present invention is described below.

As mentioned above, a method for forming insulating film between interconnect layers in semiconductor devices of the present invention comprises the steps of: providing a resinous solution by dissolving the siloxane-based resin in an organic solvent; coating a silicon wafer with the resinous solution; and heating the coated wafer to cure the resin.

According to the present invention, the resinous solution can further comprise a porogen, which is a pore-generating material. Non-limiting examples of the porogen useful in the present invention include cyclodextrin and derivatives thereof described in Korean Patent Appln. No. 2001-15883, as well as polycaprolactone and derivatives thereof described in U.S. Patent No. 6,114,458. Preferred mixing ratio of the siloxane-based resin vs. porogen is between 99:1 and 30:70(w/w), more preferably 90:10 and 50:50(w/w).

Preferred organic solvents used in dissolution of the siloxane-based resin or a mixture of the siloxane-based resin and porogen to provide a resinous solution can be exemplified by, but are not limited to, aliphatic hydrocarbon solvents; aromatic hydrocarbon solvents such as anisole, mesitylene and xylene; ketone-based solvents such as methyl isobutyl ketone, 1-methyl-2-pyrrolidinone, cyclohexanone and acetone; ether-based solvents such as tetrahydrofuran and isopropyl ether; acetate-based solvents such as ethyl acetate, butyl acetate and propylene glycol methyl ether acetate; alcohol-based solvents such as isopropyl alcohol, butyl alcohol and octyl alcohol; amide-based solvents such as dimethylacetamide and dimethylformamide; silicon-based solvents; and mixtures thereof.

Upon preparing a resinous solution, the organic solvent should be used in a sufficient amount to apply the resin component evenly on the surface of a wafer. Thus, the organic solvent is added to the siloxane-based resin or to the mixture of the siloxane-based resin and porogen so that final concentration of the solid matter(inclusive of the siloxane-based resin and the porogen) is 0.1-80wt%, preferably 5-40wt%.

Non-limiting examples of the method for coating a silicon wafer with the resinous solution thus prepared include spin-coating, dip-coating, spray-coating, flow-coating, and screen-printing, while spin-coating is most preferred. For spin coating, the spin rate is controlled to be between 1,000 and 5,000rpm.

After the coating, the organic solvent is evaporated from the wafer so that a resinous film comprising the siloxane-based resin can deposit on the wafer. At this time, the evaporation may be carried out by simple air-drying, or by subjecting the wafer, at the beginning of following curing step, to a vacuum condition or mild heating(≤100°C).

Subsequently, the resinous film is cured by heating for 1-150min at a temperature of 150-600°C, preferably 200-450°C, so as to provide a insoluble, crack-free film. As used herein, by "crack-free film" is meant a film without any crack observed with an optical microscope at a magnification of 1000X. As used herein, by "insoluble film" is meant a film that is substantially insoluble in any solvent described as being useful for dissolving the siloxane-based resins.

The coating film thus formed was found to have dielectric constant below 3.0, preferably between 2.0 and 2.7, and so it is very useful as an insulating film between interconnect layers in semiconductor devices.

The present invention can be more clearly understood with referring to the following examples. It should be understood that the following examples are not intended to restrict the scope of the present invention in any manner.

**Production Example 1: Synthesis of cyclic siloxane monomers**

**Production Example 1-1: Synthesis of monomer (A)**

To a flask were added 10.0g(29.014mmol) of 2,4,6,8-tetramethyl-2,4,6,8-tetravinylcyclotetrasiloxane and 0.164g of platinum(O)-1,3-divinyl-1,1,3,3-tetramethyldisiloxane complex(solution in xylene), and then diluted with 300ml of diethylether. Next, the flask was cooled to -78°C, 17.29g(127.66mmol) of trichlorosilane was slowly added thereto, and then it was slowly warmed to room temperature. The reaction was continued at room temperature for 20hrs, and volatile materials were removed from the reaction mixture under a reduced pressure of about 0.1Torr. To the mixture was added 100ml of pentane and stirred for 1hr, and then the mixture was filtered through celite. From the filtrate was evaporated pentane under a reduced pressure of about 0.1Torr to afford a liquid compound represented by the following formula:

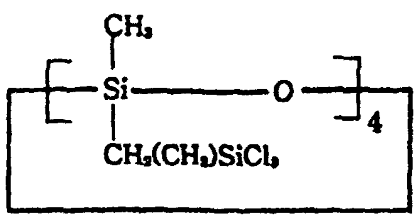

10.0g(11.28mmol) of the liquid compound was diluted with 500ml of tetrahydrofuran, and 13.83g(136.71mmol) of triethylamine was added thereto. Thereafter, the mixture was cooled to -78°C, 4.38g(136.71mmol) of methyl alcohol was slowly added thereto, and then it was slowly warmed to room temperature. The reaction was continued at room temperature for 15hrs and filtered through celite, and then volatile materials were evaporated from the filtrate under a reduced pressure of about 0.1Torr. Subsequently, 100ml of pentane was added to the filtrate and stirred for 1hr, and then the mixture was filtered through celite to provide a clear colorless solution. Finally, pentane was evaporated from this solution under a reduced pressure of about 0.1Torr to afford monomer (A) represented by the following formula:

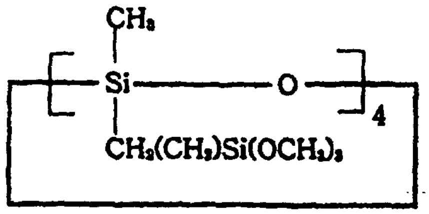

The results obtained from NMR analysis of monomer (A) dissolved in $CDCl_3$ are as follows:
$^1$H-NMR(300MHz): δ 0.09(s, 12H, 4×-$CH_3$), 0.52~0.64(m, 16H, 4×-$CH_2CH_2$-), 3.58(s, 36H, 4×-[$OCH_3$]$_3$)

**Production Example 1-2: Synthesis of monomer (B)**

To a flask were added 2.0g(8.32mmol) of 2,4,6,8-tetramethylcyclotetrasiloxane and 0.034g of platinum(O)-1,3-divinyl-1,1,3,3-tetramethyldisiloxane complex(solution in xylene), and then diluted with 100ml of toluene, followed by addition of 7.75g(33.36mmol) of trimethoxy(7-octene-1-yl)silane. Next, the flask was slowly warmed to 75°C. The reaction was continued at 75°C for 36hrs, and then volatile materials were removed therefrom under a reduced pressure of about 0.1Torr. To the reaction mixture was added 100ml of pentane and stirred for 1hr, and then the mixture was filtered through celite. Subsequently, pentane was evaporated from the filtrate under a reduced pressure of about 0.1Torr to afford monomer (B) represented by the following formula:

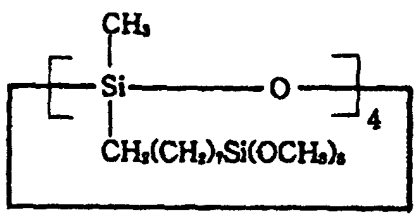

The results obtained from NMR analysis of monomer (B) dissolved in CDCl3 are as follows:
$^1$H-NMR(300MHz): δ 0.11(s, 12H, 4×-$CH_3$), 0.48~0.53(m, 8H, 4×-$CH_2$-), 0.86~0.90(m, 8H, 4×-$CH_2$-), 1.15~1.71(m, 48H, 4×-[$CH_2$]$_6$), 3.58(s, 36H, 4×-[$OCH_3$]$_3$)

**Production Example 2: Synthesis of cage-shape siloxane monomers**

**Production Example 2-1: Synthesis of monomer (C)**

To a flask was added 10.0g(7.194mmol) of octa(chlorosilylethyl)-POSS[Polyhedral Oligomeric Silsesquioxane] and diluted with 500ml of tetrahydrofuran, followed by addition of 6.41g(63.310mmol) of triethylamine. Next, the flask was cooled to -78°C, and 2.03g(63.310mmol) of methyl alcohol was slowly added thereto, and then it was slowly warmed to room temperature. The reaction was continued at room temperature for 20hrs, filtered through celite, and then volatile materials were evaporated from the filtrate under a reduced pressure of about 0.1Torr. Subsequently, 100ml of pentane was added to the filtrate and stirred for 1hr, and then the mixture was filtered through celite to provide a clear colorless solution. Finally, pentane was evaporated from this solution under a reduced pressure of about 0.1Torr to afford monomer (C) represented by the following formula:

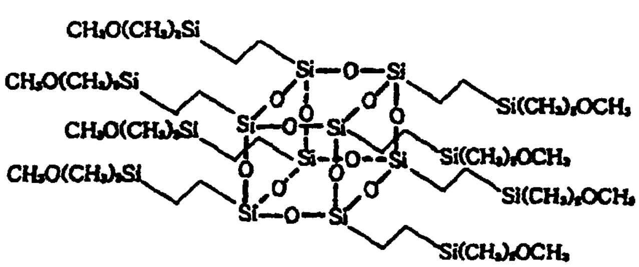

The results obtained from NMR analysis of monomer (C) dissolved in $CDCl_3$ are as follows:
$^1$H-NMR(300MHz): δ 0.11(s, 48H, 8×-[$CH_3$]$_2$), 0.54~0.68(m, 32H, 8×-$CH_2CH_2$-), 3.43(s, 24H, 8×-$OCH_3$)

**Production Example 2-2: Synthesis of monomer (D)**

To a flask was added 10.0g(6.438mmol) of octa(dichlorosilylethyl)-POSS and diluted with 500ml of tetrahydrofuran, followed by addition of 11.47g(113.306mmol) of triethylamine. Next, the flask was cooled to -78°C, and 3.63g (113.306mmol) of methyl alcohol was slowly added thereto, and then it was slowly warmed to room temperature. The

reaction was continued at room temperature for 20hrs, filtered through celite, and then volatile materials were evaporated from the filtrate under a reduced pressure of about 0.1Torr. Subsequently, 100ml of pentane was added to the filtrate and stirred for 1hr, and then the mixture was filtered through celite to provide a clear colorless solution. Finally, pentane was evaporated from this solution under a reduced pressure of about 0.1Torr to afford monomer (D) represented by the following formula:

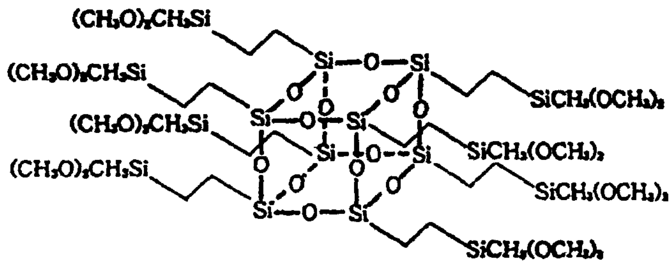

The results obtained from NMR analysis of monomer (D) dissolved in $CDCl_3$ are as follows:
$^1$H-NMR(300MHz): δ 0.12(s, 24H, 8×-$CH_3$), 0.56~0.70(m, 32H, 8×-$CH_2CH_2$-), 3.46(s, 48H, 8×-$[OCH_3]_2$)

**Production Example 2-3: Synthesis of monomer (E)**

To a flask was added 5.0g(2.913mmol) of octa(trichlorosilylethyl)-POSS and diluted with 500ml of tetrahydrofuran, followed by addition of 7.78g(76.893mmol) of triethylamine. Next, the flask was cooled to -78°C, and 2.464g (76.893mmol) of methyl alcohol was slowly added thereto, and then it was slowly warmed to room temperature. The reaction was continued at room temperature for 20hrs, filtered through celite, and then volatile materials were evaporated from the filtrate under a reduced pressure of about 0.1Torr. Subsequently, 100ml of pentane was added to the filtrate and stirred for 1hr, and then the mixture was filtered through celite to provide a clear colorless solution. Finally, pentane was evaporated from this solution under a reduced pressure of about 0.1Torr to afford monomer (E) represented by the following formula:

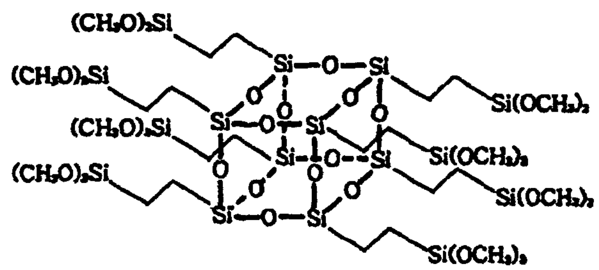

The results obtained from NMR analysis of monomer (E) dissolved in $CDCl_3$ are as follows:
$^1$H-NMR(300MHz): δ 0.66~0.69(m, 32H, 8×-$CH_2CH_2$-), 3.58(s, 72H, 8×-$[OCH_3]_3$)

**Example 1: Synthesis of siloxane-based resins**

**Example 1-1: Copolymerization of cyclic and cage-shape siloxane monomers**

Cyclic and cage-shape siloxane monomers were quantified respectively according to Table 1, and then added to a flask, followed by dilution with 45ml of tetrahydrofuran. Thereafter, the flask was cooled to -78°C, and HCl and deionized water were slowly added thereto at the same temperature, and then it was slowly warmed to 70°C. The reaction was continued at 70°C for 16hrs, and transferred to a separatory funnel, followed by addition of 90ml of diethylether. After washing with 3X50ml of deionized water, volatile materials were evaporated from the remaining solution to afford a white powdery polymer. The powder was dissolved in a small amount of acetone, and filtered through a 0.2μm syringe filter so as to remove impurities to provide a clear filtrate. After addition of water to the filtrate, the

resulting white powder was separated from the liquid phase(mixed solution of acetone and water), and then dried at a temperature of 0-5°C under a reduced pressure of about 0.1Torr to afford a fractionated siloxane-based resin.

Table 1

| Resin | Monomers | | HCl (mmol) | $H_2O$ (mmol) | Yield (g) |
|---|---|---|---|---|---|
| | Cyclic siloxane | Cage-shape siloxane | | | |
| (a) | Monomer (A) 13.294mmol | Monomer (C) 1.476mmol | 1.713 | 570.96 | 6.15 |
| (b) | Monomer (A) 12.142mmol | Monomer (D) 1.349mmol | 1.673 | 557.56 | 6.04 |
| (c) | Monomer (B) 12.136mmol | Monomer (D) 1.349mmol | 1.673 | 557.56 | 5.17 |
| (d) | Monomer (A) 11.183mmol | Monomer (E) 1.242mmol | 1.640 | 546.70 | 4.11 |

**Example 1-2: Copolymerization of cyclic and cage-shape siloxane monomers together with a silane monomer of formula (3)**

Cyclic and cage-shape siloxane monomers as well as tetramethoxysilane as a silane monomer of formula (3) were quantified respectively according to Table 2, and then added to a flask, followed by dilution with 50ml of tetrahydrofuran. Thereafter, the flask was cooled to -78°C, and HCl and deionized water were slowly added thereto at the same temperature, and then it was slowly warmed to 60°C. The reaction was continued at 60°C for 16hrs, and transferred to a separatory funnel, followed by addition of 150ml of diethylether. After washing with 3X50ml of deionized water, volatile materials were evaporated from the remaining solution to afford a white powdery polymer. The powder was dissolved in a small amount of acetone, and filtered through a 0.2μm syringe filter so as to remove impurities to provide a clear filtrate. After addition of water to the filtrate, the resulting white powder was separated from the liquid phase(mixed solution of acetone and water), and then dried at a temperature of 0-5°C under a reduced pressure of about 0.1Torr to afford a fractionated siloxane-based resin.

Table 2

| Resin | Monomers (mmol) | | | HCl (mmol) | $H_2O$ (mmol) | Yield (g) |
|---|---|---|---|---|---|---|
| | Cyclic siloxane | Cage-shape siloxane | Silane | | | |
| | Monomer (A) | Monomer (C) | Tetramethoxysilane | | | |
| (e) | 10.799 | 1.200 | 5.144 | 1.598 | 532.494 | 5.37 |

**Example 1-3: Copolymerization of cyclic and cage-shape siloxane monomers together with silane monomers of formulas (3) and (4)**

The procedure of Example 1-3 was conducted according to the same manner as in the above Example 1-2, except that methyltrimethoxysilane was additionally used as a silane monomer of formula (4).

Table 3

| Resin | Monomers (mmol) | | | | HCl (mmol) | $H_2O$ (mmol) | Yield (g) |
|---|---|---|---|---|---|---|---|
| | Cyclic siloxane | Cage-shape siloxane | Silane | | | | |
| | Monomer (A) | Monomer (C) | Tetramethoxysilane | Methyltrimethoxysilane | | | |
| (f) | 9.598 | 1.200 | 5.144 | 1.197 | 1.490 | 496.428 | 4.76 |

**Example 1-4: Copolymerization of a cyclic siloxane monomer together with a silane monomer of formula (3)**

The procedure of Example 1-4 was conducted according to the same manner as in the above Example 1-2, except that the cage shape siloxane monomer was omitted.

Table 4

| Resin | Monomers (mmol) | | HCl (mmol) | $H_2O$ (mmol) | Yield (g) |
|---|---|---|---|---|---|
| | Cyclic siloxane | Silane | | | |
| | Monomer (A) | Tetramethoxysilane | | | |
| (g) | 5.999 | 0.667 | 0.747 | 248.828 | 2.39 |
| (h) | 5.999 | 2.571 | 0.823 | 274.213 | 2.46 |
| (i) | 5.999 | 5.999 | 0.960 | 319.915 | 2.53 |

**Example 1-5: Copolymerization of a cyclic siloxane monomer together with silane monomers of formulas (3) and (4)**

The procedure of Example 1-5 was conducted according to the same manner as in the above Example 1-4, except that methyltrimethoxysilane was additionally used as a silane monomer of formula (4).

Table 5

| Resin | Monomers (mmol) | | | HCl (mmol) | $H_2O$ (mmol) | Yield (g) |
|---|---|---|---|---|---|---|
| | Cyclic siloxane | Silane | | | | |
| | Monomer (A) | Tetramethoxysilane | Methyltrimethoxysilane | | | |
| (j) | 10.799 | 5.144 | 1.197 | 1.538 | 512.466 | 5.04 |

**Example 1-6: Copolymerization of a cage-shape siloxane monomer together with a silane monomer of formula (4)**

The procedure of Example 1-6 was conducted according to the same manner as in the above Example 1-1, except that a silane monomer of formula (4), methyltrimethoxysilane was used instead of the cyclic siloxane monomer.

Table 6

| Resin | Monomers | | HCl (mmol) | $H_2O$ (mmol) | Yield (g) |
|---|---|---|---|---|---|
| | Cage-shape siloxane | Silane | | | |
| (k) | Monomer (C) 1.476mmol | Methyltrimethoxysilane 13.287mmol | 0.00517 | 172.36 | 2.03 |
| (l) | Monomer (D) 1.349mmol | Methyltrimethoxysilane 12.113mmol | 0.00580 | 193.36 | 1.95 |

**Example 2: Analysis of the composition of resins**

The respective siloxane-based resins obtained from the above Examples 1-1 through 1-6 were analyzed for weight average molecular weight(hereinafter, referred to as "Mw"), molecular weight distribution(hereinafter, referred to as "MWD"), weight loss, and contents of Si-OH, Si-$OCH_3$ and Si-$CH_3$, as described below. The results are set forth in Table 7.

Table 7

| Resin | MW | MWD | Si-OH (%) | Si-$OCH_3$ (%) | Si-$CH_3$ (%) | Weight loss (%) |
|---|---|---|---|---|---|---|
| (a) | 63418 | 6.13 | 26.3 | 0.7 | 73.0 | 4.5 |

Table 7 (continued)

| Resin | MW | MWD | Si-OH (%) | Si-$OCH_3$ (%) | Si-$CH_3$ (%) | Weight loss (%) |
|---|---|---|---|---|---|---|
| (b) | 66614 | 8.59 | 37.6 | 0.6 | 61.8 | 4.1 |
| (c) | 89860 | 8.34 | 39.7 | 0.8 | 59.5 | 3.8 |
| (d) | 67145 | 7.86 | 28.6 | 1.7 | 69.7 | 3.7 |
| (e) | 60452 | 8.70 | 17.2 | 0.8 | 82.0 | N.D.[1)] |
| (f) | 54213 | 7.86 | 21.6 | 2.0 | 76.4 | N.D. |
| (g) | 29316 | 7.85 | 35.1 | 1.3 | 63.6 | N.D. |
| (h) | 26778 | 7.46 | 37.1 | 1.5 | 61.4 | N.D. |
| (i) | 19904 | 6.30 | 27.1 | 1.5 | 71.4 | N.D. |
| (j) | 23654 | 6.53 | 28.3 | 1.9 | 69.8 | N.D. |
| (k) | 6878 | 6.15 | 12.9 | 0.9 | 86.2 | 4.2 |
| (l) | 6904 | 5.70 | 30.6 | 1.4 | 68.0 | 4.6 |

1) N.D.: not determined

[Analytical methods]

- Mw and MWD: analyzed by gel permeation chromatography(Waters Co.)
- Si-OH, Si-$OCH_3$ and Si-$CH_3$ contents(%): analyzed by NMR (Bruker Co.)

$$\text{Si-OH}(\%)=\text{Area(Si-OH)}/[\text{Area(Si-OH)}+\text{Area(Si-OCH}_3)+\text{Area(Si-CH}_3)] \times 100$$

$$\text{Si-OCH}_3(\%)=\text{Area(Si-OCH}_3)/[\text{Area(Si-OH)}+\text{Area(Si-OCH}_3)+\text{Area(Si-CH}_3)] \times 100$$

$$\text{Si-CH}_3(\%)=\text{Area(Si-CH}_3)/[\text{Area(Si-OH)}+\text{Area(Si-OCH}_3)+\text{Area(Si-CH}_3)] \times 100$$

- Weight loss(%): analyzed by a thermogravimetric analyzer(TA instruments Co.)

**Example 3: Measurement of thickness, refractive index and dielectric constant of resinous films**

With or without being mixed with a porogen, heptakis(2,3,6-tri-O-methyl)-β-cyclodextrin in a mixing ratio by weight according to Table 8, each of the siloxane-based resins obtained from the above Examples 1-1 through 1-6 was dissolved, respectively, in either methylisobutylketone(MIBK) or propylene glycol methyl ether acetate(PGMEA), so that final concentration of the solid matter(inclusive of the resin and the porogen) in the resulting resinous solution amounted to 25wt%. The resinous solution was spin-coated onto a silicon wafer for 30sec with maintaining the spin rate of 3,000rpm. Under a nitrogen atmosphere, the coated wafer was subjected to sequential soft baking on a hot plate for 1min at either 100°C (for resin e, f, g, h, i, j) or 150°C(for resin a, b, c, d, k, l) and for another minute at 250°C, to remove the organic solvent sufficiently. Thereafter, the temperature of the wafer was elevated to either 400°C(for resin a, b, c, d, k, l) or 420°C(for resin e, f, g, h, i, j) at a rate of 3°C/min under vacuum condition, and then the wafer was cured at the same temperature for 1hr to afford a test piece.

Each of the test pieces thus prepared was analyzed for film thickness by using a prism coupler, an ellipsometer, and a profiler. Also, dielectric constant of the film was determined by using Hg CV meter(SSM 490i CV system, Solid State Measurements), at a frequency of approximately 1MHz in the gate voltage range of -220V through 220V as follows. Capacitance of a control piece coated with a reference material(e.g. thermal silicon oxide), whose film thickness and dielectric constant had been previously determined, was first measured. Then, contact area between a Hg electrode and the control piece was calculated from the following equation (1) and set down as a reference value:

$$A = C \times t / k \quad (1)$$

(wherein, "A" is the contact area between the Hg electrode and the control piece, "C" is the capacitance of the control piece measured above, "t" is the film thickness of the control piece, and "k" is the dielectric constant of the reference material(3.9 for thermal silicon oxide used herein).

Once capacitance of the test piece is found out from C-V measurement by using the Hg CV meter, film thickness of the test piece corresponding to the reference dielectric constant k=3.9, based on the capacitance and the reference "A", is determined from the above equation (1), and hereinafter referred to as "conversion thickness". Subsequently, the conversion thickness($t_{conv.}$) and the real film thickness($t_{test\ piece}$) of the test piece, which was previously determined as described above, are substituted into the following equation (2), to provide dielectric constant "k" of the test piece:

$$k_{test\ piece} = 3.9 \times t_{test\ piece} / t_{conv.} \quad (2)$$

The dielectric constants thus determined are set forth in Table 8 together with the film thickness.

Table 8

| Resin | Resinous solution | R:P[1)] | Solvent | Prism coupler | | Ellipsometer | | Profiler | Dielectric constant |
|---|---|---|---|---|---|---|---|---|---|
| | | | | T[2)] (Å) | R[3)] | T (Å) | R | T (Å) | |
| (a) | (a) | 100:0 | MIBK | 8168 | 1.433 | | | 7751 | 2.26 |
| (b) | (b) | | " | 8676 | 1.426 | 8700 | 1.426 | 8246 | 2.34 |
| (c) | (c) | | " | 8050 | 1.435 | | | 7961 | 2.31 |
| (d) | (d) | | " | 8565 | 1.427 | | | 8412 | 2.42 |
| (e) | (e) | | PGMEA | 12190 | 1.4263 | 12230 | 1.430 | 11968 | 2.42 |
| | (e-1) | 70:30 | " | 10606 | 1.3463 | 10651 | 1.345 | 10521 | 2.29 |
| (f) | (f) | 100:0 | " | 9164 | 1.4364 | 9224 | 1.433 | 9095 | 2.47 |
| | (f-1) | 70:30 | " | 9806 | 1.3465 | 9901 | 1.340 | 9767 | 2.27 |
| (g) | (g) | 100:0 | " | 10032 | 1.4333 | 10125 | 1.431 | 9931 | 2.49 |
| | (g-1) | 90:10 | " | 9674 | 1.3921 | 9855 | 1.386 | 9536 | 2.35 |
| | (g-2) | 50:50 | " | 10282 | 1.3109 | 10230 | 1.315 | 10103 | 1.67 |
| (h) | (h) | 100:0 | " | 9428 | 1.4339 | 9589 | 1.433 | 9321 | 2.64 |
| | (h-1) | 90:10 | " | 9344 | 1.3966 | 9252 | 1.395 | 9341 | 2.41 |
| | (h-2) | 70:30 | " | 9425 | 1.3510 | 9411 | 1.321 | 9420 | 2.17 |
| (i) | (i) | 100:0 | " | 9208 | 1.4312 | 9380 | 1.432 | 9100 | 2.65 |
| | (i-1) | 90:10 | " | 9099 | 1.3964 | 9112 | 1.384 | 9056 | 2.49 |
| | (i-2) | 70:30 | " | 9781 | 1.3435 | 9653 | 1.311 | 9653 | 2.26 |
| | (i-3) | 50:50 | " | 10738 | 1.3125 | 10023 | 1.309 | 10562 | 1.51 |
| (j) | (j) | 100:0 | " | 8518 | 1.4414 | 8574 | 1.441 | 8514 | 2.51 |
| | (j-1) | 70:30 | " | 8432 | 1.3356 | 8534 | 1.330 | 8234 | 2.31 |
| (k) | (k) | 100:0 | MIBK | 7335 | 1.420 | 7367 | 1.422 | 6584 | 2.30 |
| (l) | (l) | 100:0 | " | 7535 | 1.424 | 7644 | 1.423 | 7055 | 2.34 |

1) resin:porogen(w/w)
2) thickness
3) refractive index

**Example 4: Analysis of resinous films for mechanical properties**

**Example 4-1: Measurement of hardness and modulus of resinous films**

Some of the resinous films formed in the above Example 3 were analyzed for hardness and modulus by using Nanoindenter II(MTS Co.). The film was indented until the indentation depth reached 10% of its whole thickness, which had been previously measured by use of a prism coupler. At this time, to secure the reliability of this measurement, 6 points were indented every test piece, and mean hardness and modulus were determined from a load-displacement curve. The results are set forth in Table 9.

Table 9

| Resinous solution | Mechanical properties | |
|---|---|---|
| | Hardness(Gpa) | Modulus(Gpa) |
| (e) | 0.85 | 4.93 |
| (e-1) | 0.38 | 2.87 |
| (f) | 0.89 | 5.57 |
| (f-1) | 0.37 | 2.79 |
| (g) | 1.00 | 6.16 |
| (g-1) | 0.72 | 4.56 |
| (g-2) | 0.34 | 2.74 |
| (h) | 1.06 | 6.36 |
| (h-1) | 0.83 | 4.70 |
| (h-2) | 0.54 | 3.78 |
| (i) | 1.04 | 6.62 |
| (i-1) | 0.82 | 5.07 |
| (i-2) | 0.48 | 3.52 |
| (i-3) | 0.38 | 2.90 |
| (j) | 1.06 | 6.72 |
| (j-1) | 0.46 | 3.29 |

**Example 4-2: Measurement of crack-free thickness of resinous films**

Siloxane-based resin (i) obtained from the above Example 1, and a mixture of resin (i):heptakis(2,3,6-tri-O-methyl)-β-cyclodextrin=7:3(w/w) were dissolved in propylene glycol methyl ether acetate(PGMEA), respectively, varying final concentration of the solid matter in the respective resinous solutions to 25, 27, 29, 31, 33, and 35wt%. Each of the resinous solutions was spin-coated onto a silicon wafer at a spin rate of 3,000rpm for 30sec. Under a nitrogen atmosphere, the coated wafer was baked on a hot plate for 1 min at 100° C and for another minute at 250°C, to remove the organic solvent sufficiently. Next, the temperature of the wafer was elevated to 420°C at a rate of 3°C/min under vacuum condition, and then the resinous coating film on the surface of the wafer was cured at the same temperature for 1hr to afford a test piece. In order to find crack-free thickness, the resinous film of the test piece was observed with an optical microscope. The results are set forth in Table 10.

Table 10

| R:P[1)] | Crack-free thickness(μm) |
|---|---|
| 100:0 | 1.7 |
| 70:30 | 1.5 |

1) resin (i):heptakis(2,3,6-tri-O-methyl)-β-cyclodextrin(w/w)

**Example 5: Analysis of resinous films for thermal stability**

Siloxane-based resin (i) obtained from the above Example 1, and a mixture of resin (i):heptakis(2,3,6-tri-O-methyl)-β -cyclodextrin=50:50(w/w) were dissolved in propylene glycol methyl ether acetate(PGMEA), respectively, at final concentration of 25wt%. Each of the resinous solutions was spin-coated onto a silicon wafer at a spin rate of 3,000rpm for 30sec. Under a nitrogen atmosphere, the coated wafer was baked on a hot plate for 1 min at 100°C and for another minute at 250°C, to remove the organic solvent sufficiently. Subsequently, the temperature of the wafer was elevated to 420°C at a rate of 3°C/min under vacuum condition, and then the wafer was cured at the same temperature for 1hr to afford a test piece. Film thickness and refractive index of the test piece were measured by use of a prism coupler. Thereafter, the temperature elevation and curing were repeated twice in the same manner as described above, followed by the measurement of film thickness and refractive index of the test piece. Change rates of thickness and refractive index of the respective films are set forth in Table 11.

Table 11

| R:P 1) | Thickness(Å) | | R.I. | |
|---|---|---|---|---|
| | Mean | Change rate(%) 2) | Mean | Change rate(%) 3) |
| 100:0 | 9732 | 0.21 | 1.437 | 0,07 |
| 50:50 | 13714 | 1.65 | 1.332 | 0.19 |

1) resin (i):heptakis(2,3,6-tri-O-methyl)-β-cyclodextrin(w/w)

2)

change rate of thickness(%)
=[thickness of the film cured once - thickness of the film cured three times] ÷ thickness of the film cured once x 100

3)

change rate of refractive index(%)
=[refractive index of the film cured once - refractive index of the film cured three times] ÷ refractive index of the film cured once x 100

As described above, siloxane-based resins of the present invention are useful for forming low dielectric insulating film between interconnect layers in semiconductor devices, which is excellent in mechanical properties, thermal stability and resistance to crack.

## Claims

1. A siloxane-based resin prepared by hydrolyzing and polycondensing a cyclic siloxane compound of formula (1) and a cage-shape siloxane compound of any of formulas (2a) through (2c), optionally with at least one silane compound, in an organic solvent in the presence of a catalyst and water, wherein the silane compound is substituted at Si with at least one hydrolysable group:

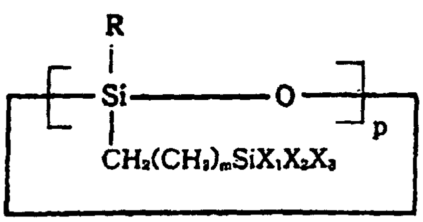

(1)

wherein,
R is H, $C_{1-3}$ alkyl, $C_{3-10}$ cycloalkyl, or $C_{6-15}$ aryl;
each of $X_1$, $X_2$, and $X_3$ is, independently, $C_{1-3}$ alkyl, $C_{1-10}$ alkoxy, or halo, provided that at least one is alkoxy or halo;
p is an integer from 3 to 8; and

m is an integer from 1 to 10;

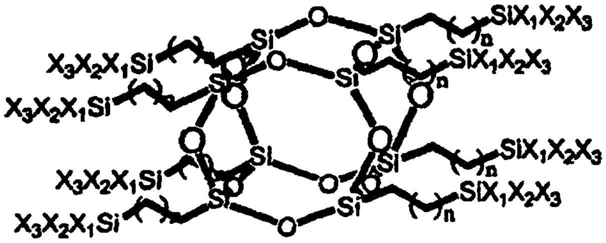

(2a)

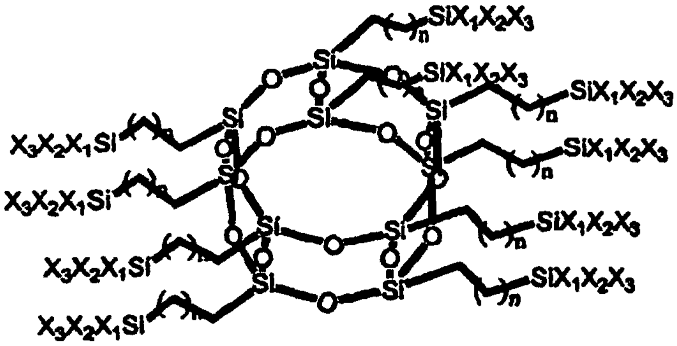

(2b)

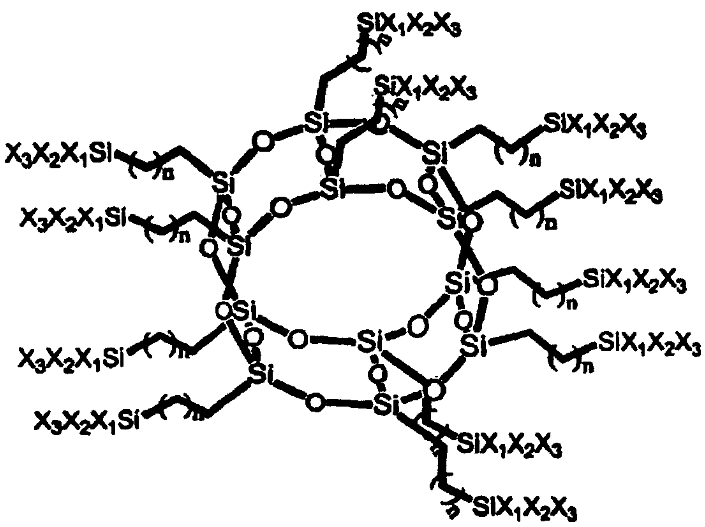

(2c)

in the above formulas (2a) through (2c),
each of $X_1$, $X_2$, and $X_3$ is, independently, $C_{1-3}$ alkyl, $C_{1-10}$ alkoxy, or halo, provided that at least one is alkoxy or halo; and
n is an integer from 1 to 12.

**2.** The siloxane-based resin according to claim 1, wherein the resin is prepared by hydrolyzing and polycondensing a cyclic siloxane compound of formula (1) and a cage-shape siloxane compound of any of formulas (2a) through

(2c), in an organic solvent in the presence of a catalyst and water:

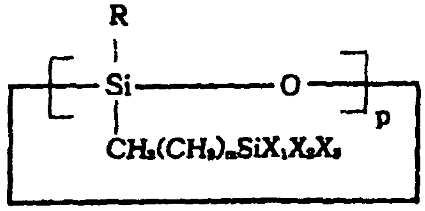

(1)

wherein,
R is H, $C_{1-3}$ alkyl, $C_{3-10}$ cycloalkyl, or $C_{6-15}$ aryl;
each of $X_1$, $X_2$, and $X_3$ is, independently, $C_{1-3}$ alkyl, $C_{1-10}$ alkoxy, or halo, provided that at least one is alkoxy or halo;
p is an integer from 3 to 8; and
m is an integer from 1 to 10;

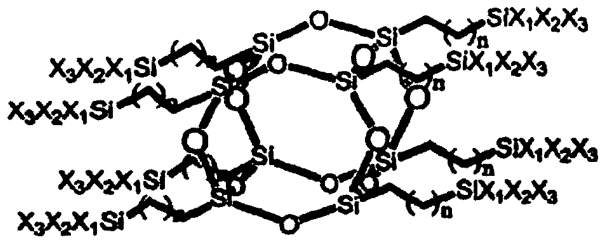

(2a)

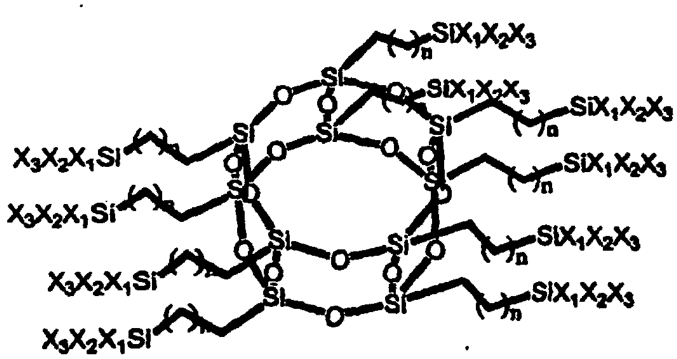

(2b)

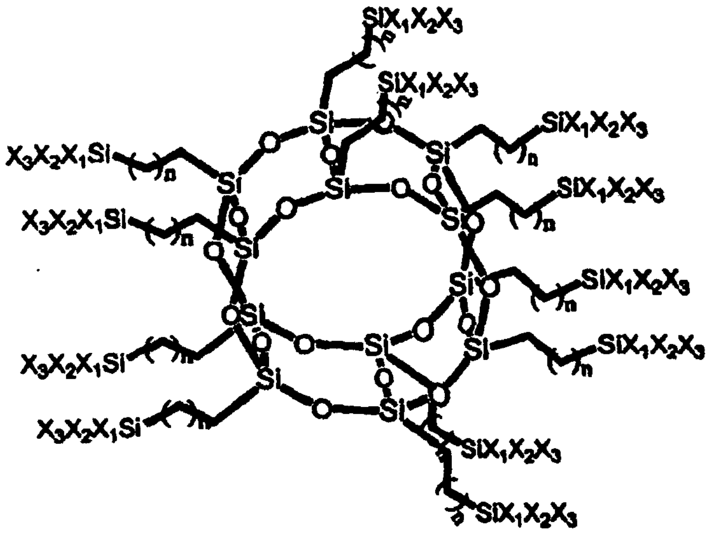

(2c)

in the above formulas (2a) through (2c),
each of $X_1$, $X_2$, and $X_3$ is, independently, $C_{1-3}$ alkyl, $C_{1-10}$ alkoxy, or halo, provided that at least one is alkoxy or halo; and
n is an integer from 1 to 12.

3. The siloxane-based resin according to claim 1, wherein the resin is prepared by hydrolyzing and polycondensing a cyclic siloxane compound of formula (1) and a cage-shape siloxane compound of any of formulas (2a) through (2c), together with a silane compound of formula (3) and/or a silane compound of formula (4), in an organic solvent in the presence of a catalyst and water:

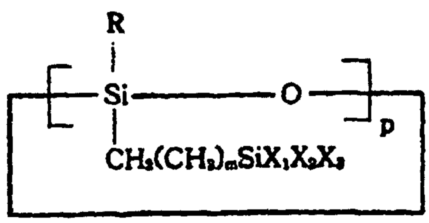

(1)

wherein,
R is H, $C_{1-3}$ alkyl, $C_{3-10}$ cycloalkyl, or $C_{6-15}$ aryl;
each of $X_1$, $X_2$, and $X_3$ is, independently, $C_{1-3}$ alkyl, $C_{1-10}$ alkoxy, or halo, provided that at least one is alkoxy or halo;
p is an integer from 3 to 8; and
m is an integer from 1 to 10;

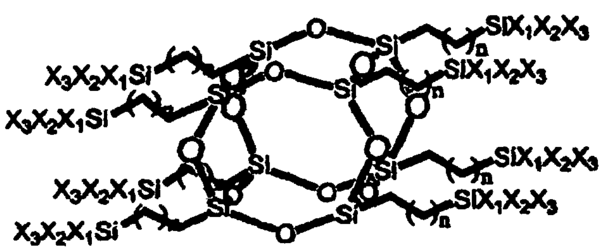

(2a)

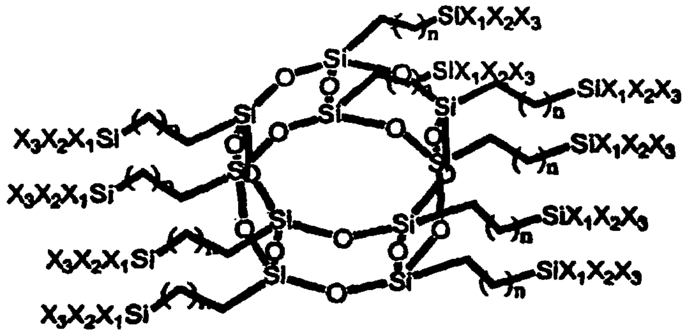

(2b)

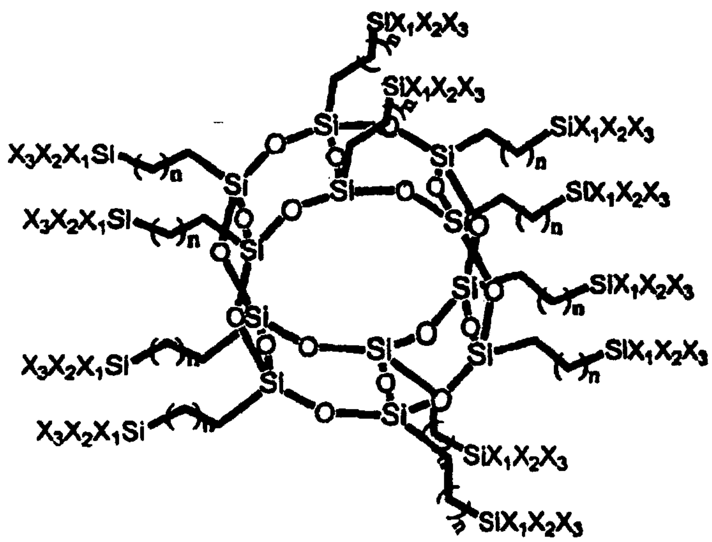

(2c)

in the above formulas (2a) through (2c),
each of $X_1$, $X_2$, and $X_3$ is, independently, $C_{1-3}$ alkyl, $C_{1-10}$ alkoxy, or halo, provided that at least one is alkoxy or halo; and
n is an integer from 1 to 12;

$$SiX_1X_2X_3X_4 \quad (3)$$

wherein,
each of $X_1$, $X_2$, $X_3$, and $X_4$ is, independently, $C_{1-10}$ alkoxy, or halo;

$$RSiX_1X_2X_3 \quad (4)$$

wherein,
R is H, $C_{1-3}$ alkyl, $C_{3-10}$ cycloalkyl, or $C_{6-15}$ aryl; and
each of $X_1$, $X_2$, and $X_3$ is, independently, $C_{1-3}$ alkyl, $C_{1-10}$ alkoxy, or halo, provided that at least one is alkoxy or halo.

**4.** A siloxane-based resin, wherein the resin is prepared by hydrolyzing and polycondensing a cyclic siloxane compound of formula (1), together with a silane compound of formula (3) and/or a silane compound of formula (4), in an organic solvent in the presence of a catalyst and water:

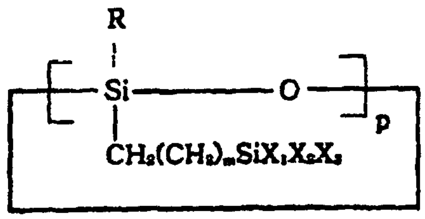

(1)

wherein,
R is H, $C_{1-3}$ alkyl, $C_{3-10}$ cycloalkyl, or $C_{6-15}$ aryl;
each of $X_1$, $X_2$, and $X_3$ is, independently, $C_{1-3}$ alkyl, $C_{1-10}$ alkoxy, or halo, provided that at least one is alkoxy or halo;
p is an integer from 3 to 8; and
m is an integer from 1 to 10;

$$SiX_1X_2X_3X_4 \quad (3)$$

wherein,
each of $X_1$, $X_2$, $X_3$, and $X_4$ is, independently, $C_{1-10}$ alkoxy, or halo;

$$RSiX_1X_2X_3 \quad (4)$$

wherein,
R is H, $C_{1-3}$ alkyl, $C_{3-10}$ cycloalkyl, or $C_{6-15}$ aryl; and
each of $X_1$, $X_2$, and $X_3$ is, independently, $C_{1-3}$ alkyl, $C_{1-10}$ alkoxy, or halo, provided that at least one is alkoxy or halo.

**5.** A siloxane-based resin, wherein the resin is prepared by hydrolyzing and polycondensing a cage-shape siloxane compound of any of formulas (2a) through (2c), together with a silane compound of formula (3) and/or a silane compound of formula (4), in an organic solvent in the presence of a catalyst and water:

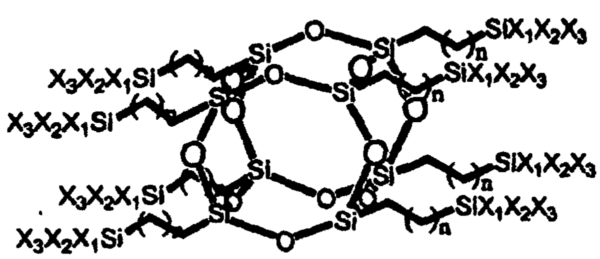

(2a)

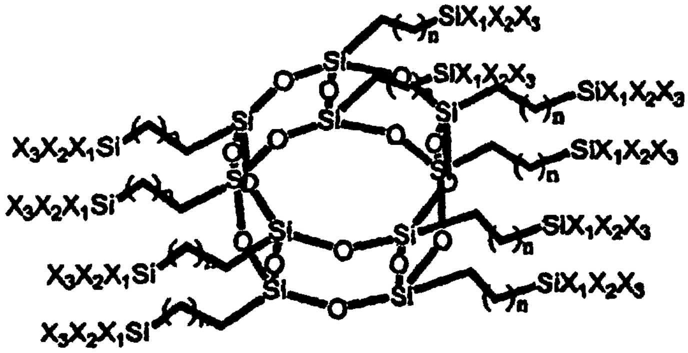

(2b)

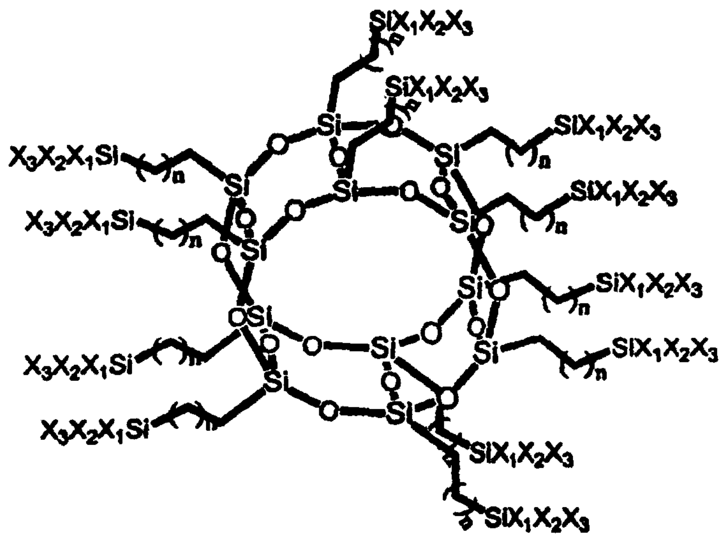

(2c)

in the above formulas (2a) through (2c),
each of $X_1$, $X_2$, and $X_3$ is, independently, $C_{1-3}$ alkyl, $C_{1-10}$ alkoxy, or halo, provided that at least one is alkoxy or halo; and
n is an integer from 1 to 12;

$$SiX_1X_2X_3X_4 \qquad (3)$$

wherein,
each of $X_1$, $X_2$, $X_3$, and $X_4$ is, independently, $C_{1-10}$ alkoxy, or halo;

$$RSiX_1X_2X_3 \qquad (4)$$

wherein,
R is H, $C_{1-3}$ alkyl, $C_{3-10}$ cycloalkyl, or $C_{6-15}$ aryl; and
each of $X_1$, $X_2$, and $X_3$ is, independently, $C_{1-3}$ alkyl, $C_{1-10}$ alkoxy, or halo, provided that at least one is alkoxy or halo.

6. The siloxane-based resin according to any of claims 1 to 5, wherein the organic solvent is an aromatic hydrocarbon solvent, an aliphatic hydrocarbon solvent, a ketone-based solvent, an ether-based solvent, an acetate-based solvent, an alcohol-based solvent, a silicon-based solvent, or a mixture thereof.

**7.** The siloxane-based resin according to any of claims 1 to 6, wherein the catalyst is hydrochloric acid, nitric acid, benzene sulfonic acid, oxalic acid, formic acid, potassium hydroxide, sodium hydroxide, triethylamine, sodium bicarbonate, pyridine, or a mixture thereof.

**8.** The siloxane-based resin according to any of claims 1 to 7, wherein 0.00001-10mol of the catalyst is added per 1mol of the monomers to be polycondensed.

**9.** The siloxane-based resin according to any of claims 1 to 8, wherein 0.1-1000mol of water is added per 1mol of the monomers to be polycondensed.

**10.** The siloxane-based resin according to any of claims 1 to 9, wherein the hydrolysis and polycondensation are performed at 0-200° C for 0.1-100hrs.

**11.** The siloxane-based resin according to any of claims 1 to 10, wherein Si-OR(wherein, R is H, $C_{1-3}$ alkyl, $C_{3-10}$ cycloalkyl, or $C_{6-15}$ aryl) content of the resin is more than 5mol%.

**12.** The siloxane-based resin according to any of claims 1 to 11, wherein Mw of the resin is between 3,000 and 500,000.

**13.** A method for forming insulating film between interconnect layers in semiconductor devices, wherein the method comprises the steps of:

providing a resinous solution by dissolving the siloxane-based resin according to any of claims 1 to 12 in an organic solvent;
coating a silicon wafer with the resinous solution; and
heat-curing the resulting coating film.

**14.** The method according to claim 13, wherein the organic solvent is an aliphatic hydrocarbon solvent, an aromatic hydrocarbon solvent, a ketone-based solvent, an ether-based solvent, an acetate-based solvent, an alcohol-based solvent, an amide-based solvent, a silicon-based solvent, or a mixture thereof.

**15.** The method according to claim 13 or 14, wherein content of the siloxane-based resin in the resinous solution is 0.1-80wt%.

**16.** The method according to any of claims 13 to 15, wherein the resinous solution further comprises a porogen, wherein weight ratio of the siloxane-based resin vs. the porogen is between 99:1 and 30:70.

**17.** The method according to claim 16, wherein the porogen is cyclodextrin, polycaprolactone, or a derivative thereof.

**18.** The method according to claim 16 or 17, wherein total content of the siloxane-based resin and the porogen in the resinous solution is 0.1-80wt%.

**19.** The method according to any of claims 13 to 18, wherein the heat-curing is performed at 150-600° C for 1-150min.

**Patentansprüche**

**1.** Siloxanharz hergestellt durch Hydrolysieren und Polykondensieren einer cyclischen Siloxanverbindung der Formel (1) und einer käfigförmigen Siloxanverbindung nach einer der Formeln (2a) bis (2c), wahlweise mit mindestens einer Silanverbindung, in einem organischen Lösemittel in Gegenwart eines Katalysators und Wasser, worin die Silanverbindung am Si mit mindestens einer hydrolysierbaren Gruppe substituiert ist:

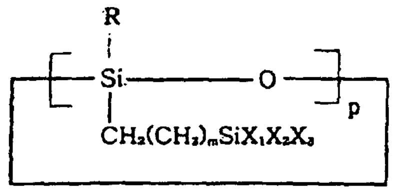

(1)

worin
R H ist, $C_{1-3}$ Alkyl, $C_{3-10}$ Cycloalkyl oder $C_{6-15}$ Aryl;
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist;
p eine ganze Zahl zwischen 3 bis 8 ist; und
m eine ganze Zahl zwischen 1 bis 10 ist;

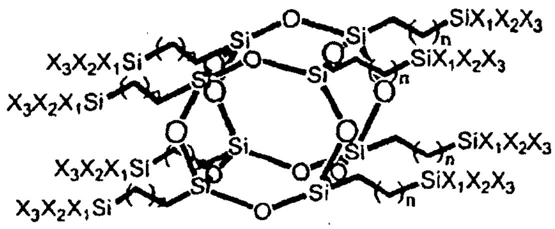

(2a)

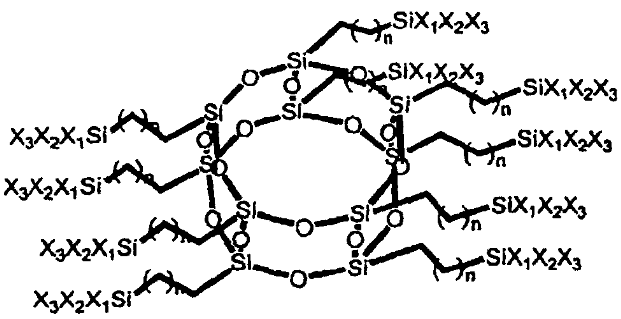

(2b)

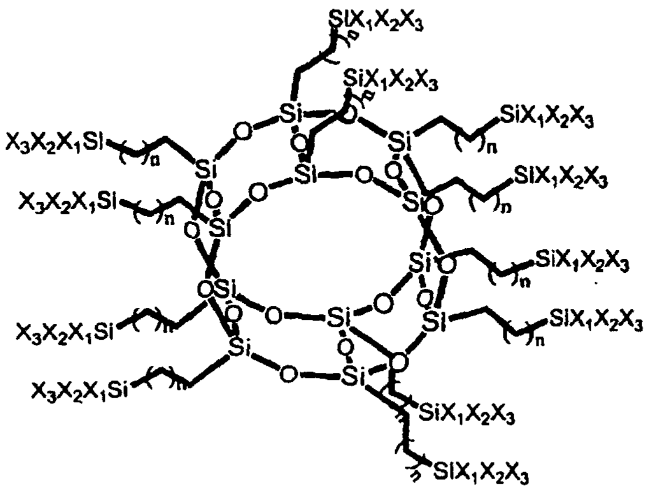

(2c)

in den obigen Formeln (2a) bis (2c) sind
jedes von $X_1$, $X_2$ und $X_3$ unabhängig $C_{1-3}$ Alkyl, $C_{1-10}$ Alkoxy oder Halogen, vorausgesetzt dass mindestens eines Alkoxy oder Halogen ist; und
n ist eine ganze Zahl zwischen 1 bis 12.

**2.** Siloxanharz nach Anspruch 1, worin das Harz hergestellt ist durch Hydrolysieren und Polykondensieren einer cyclischen Siloxanverbindung der Formel (1) und einer käfigförmigen Siloxanverbindung nach einer der Formeln (2a) bis (2c) in einem organischen Lösemittel in Gegenwart eines Katalysators und Wasser:

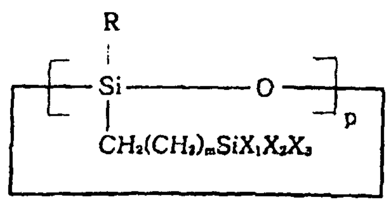

(1)

worin
R H ist, $C_{1-3}$ Alkyl, $C_{3-10}$ Cycloalkyl oder $C_{6-15}$ Aryl;
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist;
p eine ganze Zahl zwischen 3 bis 8 ist; und
m eine ganze Zahl zwischen 1 bis 10 ist;

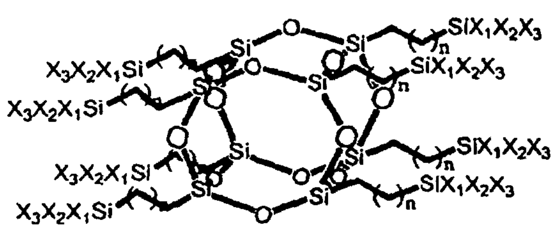

(2a)

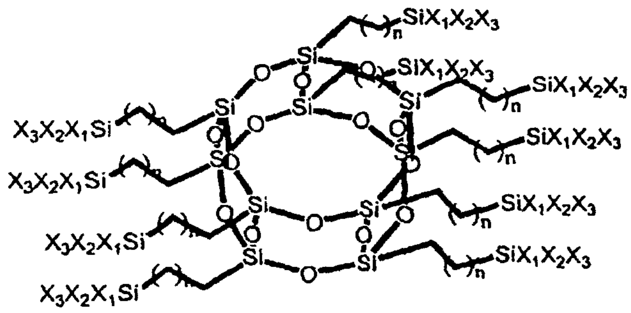

(2b)

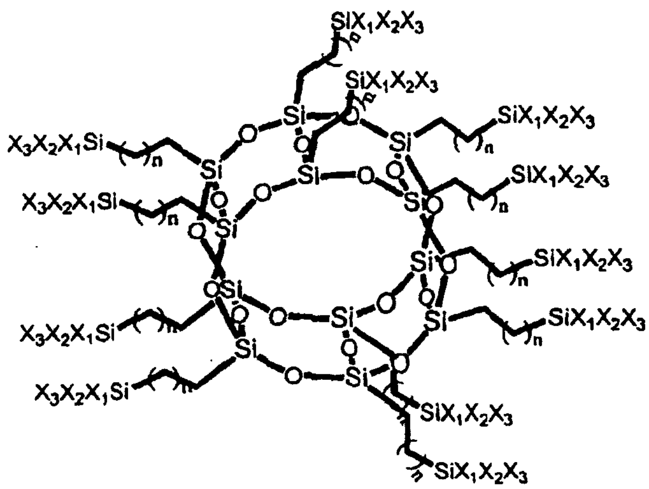

(2c)

in den obigen Formeln (2a) bis (2c) sind
jedes von $X_1$, $X_2$ und $X_3$ unabhängig $C_{1-3}$ Alkyl, $C_{1-10}$ Alkoxy oder Halogen, vorausgesetzt dass mindestens eines Alkoxy oder Halogen ist; und
n ist eine ganze Zahl zwischen 1 bis 12.

**3.** Siloxanharz nach Anspruch 1, worin das Harz hergestellt ist durch Hydrolysieren und Polykondensieren einer cyclischen Siloxanverbindung der Formel (1) und einer käfigförmigen Siloxanverbindung nach einer der Formeln (2a) bis (2c), zusammen mit einer Silanverbindung der Formel (3) und/oder einer Silanverbindung der Formel (4), in einem organischen Lösemittel in Gegenwart eines Katalysators und Wasser:

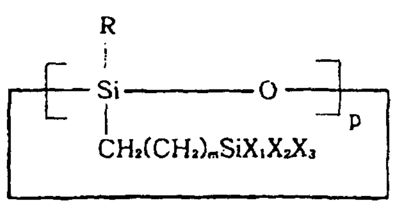

(1)

worin
R H ist, $C_{1-3}$ Alkyl, $C_{3-10}$ Cycloalkyl oder $C_{6-15}$ Aryl;
jedes von $X_1$, $X_2$ und $X_3$ unabhängig $C_{1-3}$ Alkyl, $C_{1-10}$ Alkoxy oder Halogen ist, vorausgesetzt dass mindestens

eines Alkoxy oder Halogen ist;
p eine ganze Zahl zwischen 3 bis 8 ist; und
m eine ganze Zahl zwischen 1 bis 10 ist;

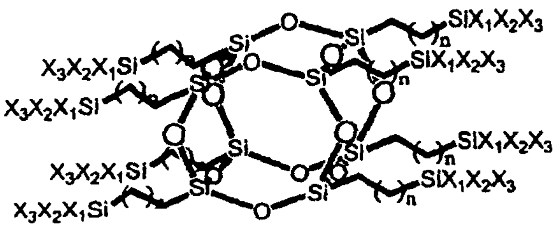

(2a)

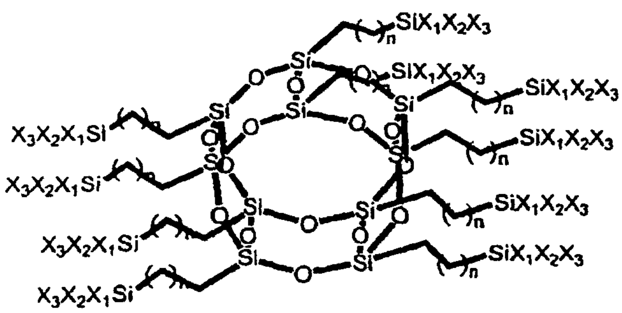

(2b)

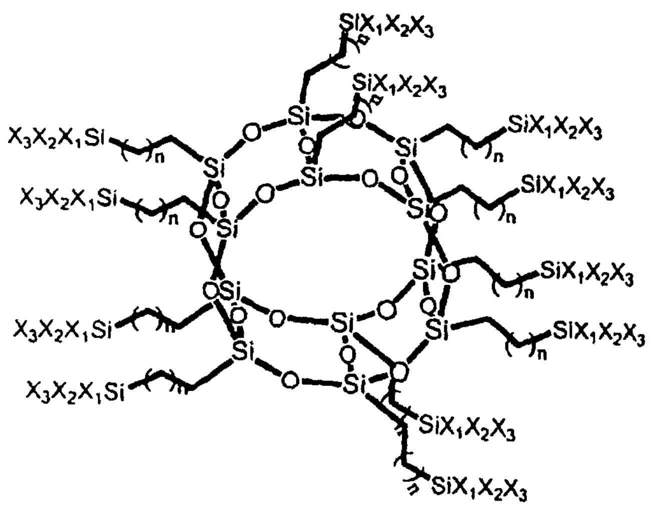

(2c)

in den obigen Formeln (2a) bis (2c) sind
jedes von $X_1$, $X_2$ und $X_3$ unabhängig $C_{1-3}$ Alkyl, $C_{1-10}$ Alkoxy oder Halogen, vorausgesetzt dass mindestens eines Alkoxy oder Halogen ist; und
n ist eine ganze Zahl zwischen 1 bis 12;

$$SiX_1X_2X_3X_4 \quad (3)$$

worin
jedes von $X_1$, $X_2$, $X_3$ und $X_4$ unabhängig $C_{1-10}$ Alkoxy oder Halogen ist;

$$RSiX_1X_2X_3 \quad (4)$$

worin
R H ist, $C_{1-3}$ Alkyl, $C_{3-10}$ Cycloalkyl oder $C_{6-15}$ Aryl; und
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist.

**4.** Siloxanharz, worin das Harz hergestellt ist durch Hydrolysieren und Polykondensieren einer cyclischen Siloxanverbindung der Formel (1), zusammen mit einer Silanverbindung der Formel (3) und/oder einer Silanverbindung der Formel (4), in einem organischen Lösemittel in Gegenwart eines Katalysators und Wasser:

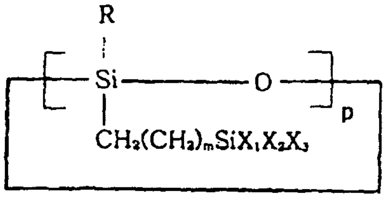

(1)

worin
R H ist, $C_{1-3}$ Alkyl, $C_{3-10}$ Cycloalkyl oder $C_{6-15}$ Aryl;
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist;
p eine ganze Zahl zwischen 3 bis 8 ist; und
m eine ganze Zahl zwischen 1 bis 10 ist;

$$SiX_1X_2X_3X_4 \quad (3)$$

worin
jedes von $X_1$, $X_2$, $X_3$ und $X_4$ unabhängig $C_{1-10}$ Alkoxy oder Halogen ist;

$$RSiX_1X_2X_3 \quad (4)$$

worin
R H ist, $C_{1-3}$ Alkyl, $C_{3-10}$ Cycloalkyl oder $C_{6-15}$ Aryl; und
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist.

**5.** Siloxanharz, worin das Harz hergestellt ist durch Hydrolysieren und Polykondensieren einer käfigförmigen Siloxanverbindung nach einer der Formeln (2a) bis (2c), zusammen mit einer Silanverbindung der Formel (3) und/oder einer Silanverbindung der Formel (4), in einem organischen Lösemittel in Gegenwart eines Katalysators und Wasser:

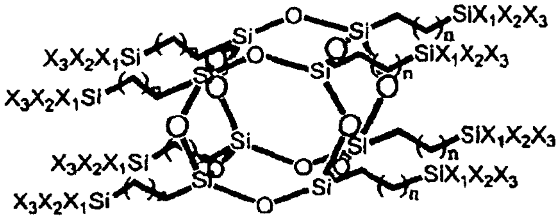

(2a)

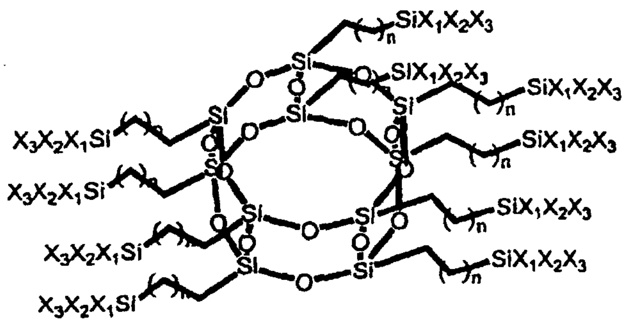

(2b)

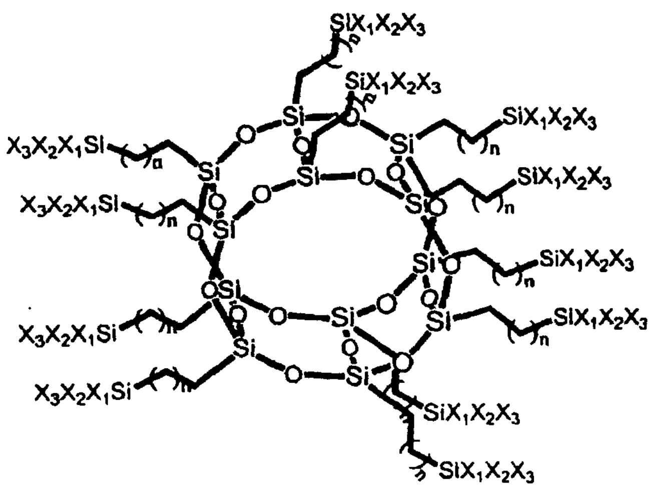

(2c)

in den obigen Formeln (2a) bis (2c) sind
jedes von $X_1$, $X_2$ und $X_3$ unabhängig $C_{1-3}$ Alkyl, $C_{1-10}$ Alkoxy oder Halogen, vorausgesetzt dass mindestens eines Alkoxy oder Halogen ist; und
n ist eine ganze Zahl zwischen 1 bis 12;

$$SiX_1X_2X_3X_4 \qquad (3)$$

worin
jedes von $X_1$, $X_2$, $X_3$ und $X_4$ unabhängig $C_{1-10}$ Alkoxy oder Halogen ist;

$$RSiX_1X_2X_3 \quad (4)$$

worin
R H ist, $C_{1-3}$ Alkyl, $C_{3-10}$ Cycloalkyl oder $C_{6-15}$ Aryl; und
jedes von $X_1$, $X_2$ und $X_3$ unabhängig $C_{1-3}$ Alkyl, $C_{1-10}$ Alkoxy oder Halogen ist, vorausgesetzt dass mindestens eines Alkoxy oder Halogen ist.

**6.** Siloxanharz nach einem der Ansprüche 1 bis 5, worin das organische Lösemittel ein aromatisches Kohlenwasserstofflösemittel ist, ein aliphatisches Kohlenwasserstofflösemittel, ein Lösemittel auf Ketonbasis, ein Lösemittel auf Etherbasis, ein Lösemittel auf Acetatbasis, ein Lösemittel auf Alkoholbasis, ein Lösemittel auf Siliciumbasis oder eine Mischung davon.

**7.** Siloxanharz nach einem der Ansprüche 1 bis 6, worin der Katalysator Salzsäure, Salpetersäure, Benzolsulfonsäure, Oxalsäure, Ameisensäure, Kaliumhydroxid, Natriumhydroxid, Triethylamin, Natriumbicarbonat, Pyridin oder eine Mischung davon ist.

**8.** Siloxanharz nach einem der Ansprüche 1 bis 7, worin 0,00001-10 mol des Katalysators pro 1 mol der Monomere zugesetzt ist, die polykondensiert werden sollen.

**9.** Siloxanharz nach einem der Ansprüche 1 bis 8, worin 0,1-1000 mol Wasser pro 1 mol der Monomere zugesetzt ist, die polykondensiert werden sollen.

**10.** Siloxanharz nach einem der Ansprüche 1 bis 9, worin die Hydrolyse und Polykondensation bei 0-200 °C über 0,1-100 Stunden durchgeführt werden.

**11.** Siloxanharz nach einem der Ansprüche 1 bis 10, worin ein Gehalt an SiOR (worin R H ist, $C_{1-3}$ Alkyl, $C_{3-10}$ Cycloalkyl oder $C_{6-15}$ Aryl) im Harz mehr als 5 mol-% beträgt.

**12.** Siloxanharz nach einem der Ansprüche 1 bis 11, worin Mw (Molekulargewicht) des Harzes zwischen 3000 und 500000 beträgt.

**13.** Verfahren zur Herstellung eines Isolierfilms zwischen Verbindungsschichten in Halbleiteranordnungen, worin das Verfahren die Schritte umfasst:

Bereitstellen einer Harzlösung durch Auflösen des Siloxanharzes nach einem der Ansprüche 1 bis 12 in einem organischen Lösemittel;
Beschichten eines Siliciumwafers mit der Harzlösung; und
Warmhärten des erhaltenen Beschichtungsfilms.

**14.** Verfahren nach Anspruch 13, worin das organische Lösemittel ein aliphatisches Kohlenwasserstofflösemittel ist, ein aromatisches Kohlenwasserstofflösemittel, ein Lösemittel auf Ketonbasis, ein Lösemittel auf Etherbasis, ein Lösemittel auf Acetatbasis, ein Lösemittel auf Alkoholbasis, ein Lösemittel auf Amidbasis, ein Lösemittel auf Siliciumbasis oder eine Mischung davon.

**15.** Verfahren nach Anspruch 13 oder 14, worin ein Gehalt an Siloxanharz in der Harzlösung 0,1-80 Gew.-% beträgt.

**16.** Verfahren nach einem der Ansprüche 13 bis 15, worin die Harzlösung ferner ein Porogen umfasst, worin das Gewichtsverhältnis des Siloxanharzes gegen das Porogen zwischen 99:1 und 30:70 liegt.

**17.** Verfahren nach Anspruch 16, worin das Porogen Cyclodextrin, Polycaprolacton oder ein Derivat davon ist.

**18.** Verfahren nach Anspruch 16 oder 17, worin ein Gesamtgehalt an Siloxanharz und Porogen in der Harzlösung 0,1-80 Gew.-% beträgt.

**19.** Verfahren nach einem der Ansprüche 13 bis 18, worin das Warmhärten bei 150-600 °C über 1-150 min durchgeführt wird.

## Revendications

**1.** Résine à base de siloxane préparée par l'hydrolyse et la polycondensation d'un composé de siloxane cyclique de formule (1) et d'un composé de siloxane en forme de cage de l'une quelconque des formules (2a) à (2c), facultativement avec au moins un composé de silane, dans un solvant organique en présence d'un catalyseur et d'eau, dans laquelle le composé de silane est substitué en Si par au moins un groupe hydrolysable :

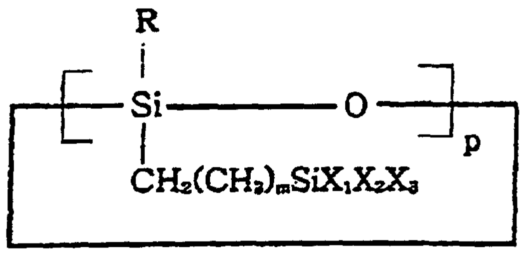

(1)

dans laquelle,
R est H, un alkyle en $C_1$ à $C_3$, un cycloalkyle en $C_3$ à $C_{10}$, ou un aryle en $C_6$ à $C_{15}$ ;
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ;
p est un entier de 3 à 8 ; et
m est un entier de 1 à 10 ;

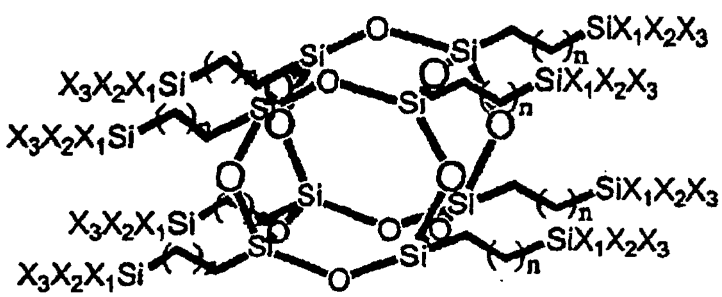

(2a)

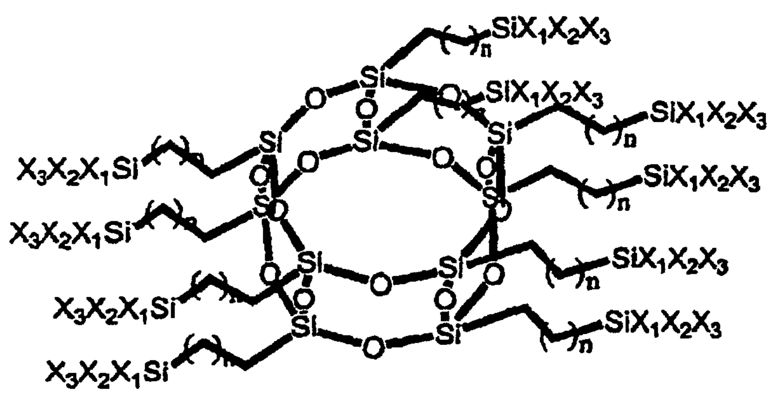

(2b)

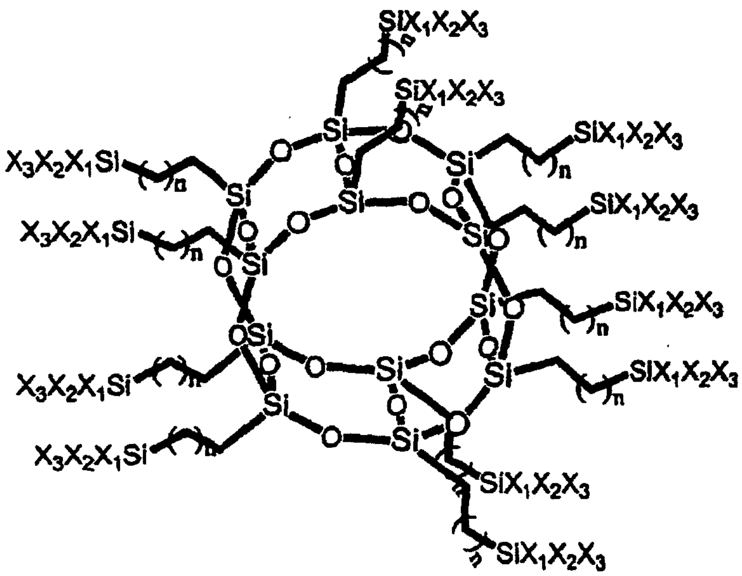

(2c)

dans les formules (2a) à (2c) ci-dessus,
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ; et
n est un entier de 1 à 12.

**2.** Résine à base de siloxane selon la revendication 1, dans laquelle la résine est préparée par l'hydrolyse et la polycondensation d'un composé de siloxane cyclique de formule (1) et d'un composé de siloxane en forme de cage de l'une quelconque des formules (2a) à (2c), dans un solvant organique en présence d'un catalyseur et d'eau :

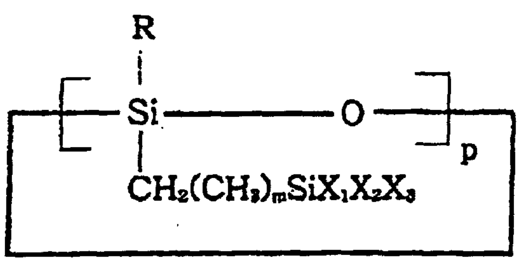

(1)

dans laquelle,
R est H, un alkyle en $C_1$ à $C_3$, un cycloalkyle en $C_3$ à $C_{10}$, ou un aryle en $C_6$ à $C_{15}$ ;
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ;
p est un entier de 3 à 8 ; et
m est un entier de 1 à 10 ;

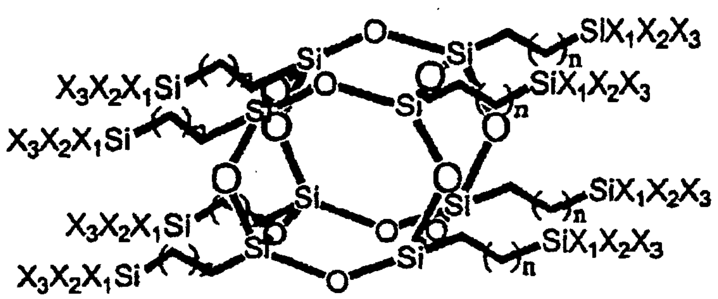

(2a)

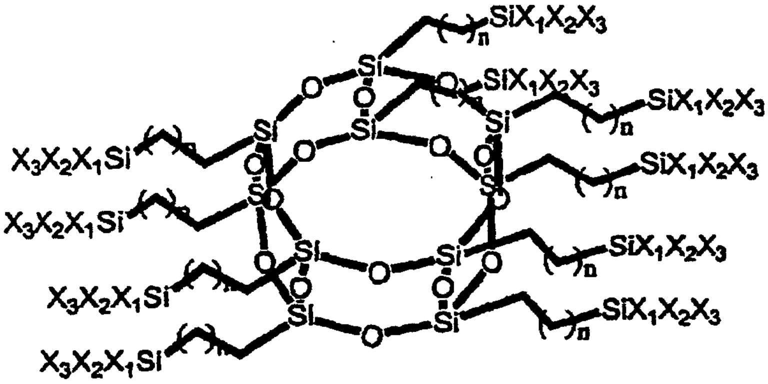

(2b)

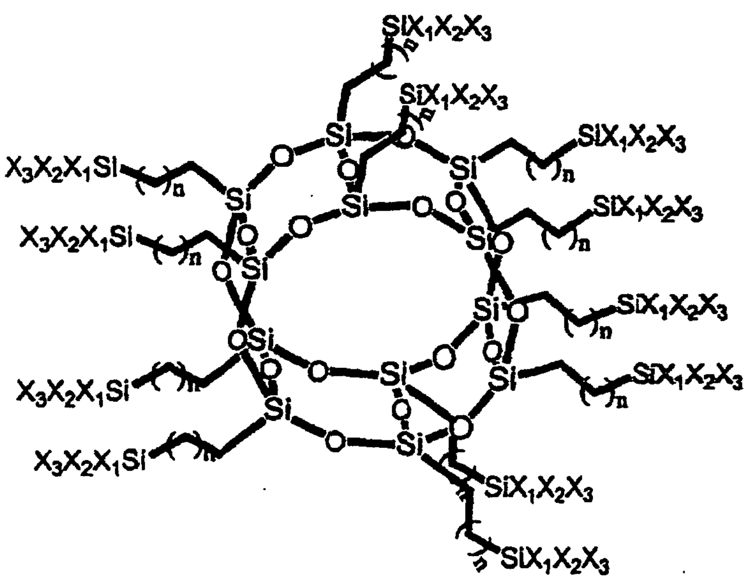

(2c)

dans les formules (2a) à (2c) ci-dessus,
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ; et
n est un entier de 1 à 12.

**3.** Résine à base de siloxane selon la revendication 1, dans laquelle la résine est préparée par l'hydrolyse et la polycondensation d'un composé de siloxane cyclique de formule (1) et d'un composé de siloxane en forme de cage de l'une quelconque des formules (2a) à (2c), conjointement avec un composé de silane de formule (3) et/ou un composé de silane de formule (4), dans un solvant organique en présence d'un catalyseur et d'eau :

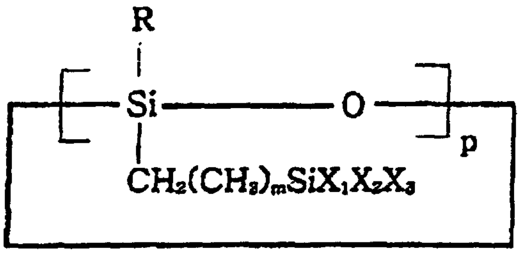

(1)

dans laquelle,
R est H, un alkyle en $C_1$ à $C_3$, un cycloalkyle en $C_3$ à $C_{10}$, ou un aryle en $C_6$ à $C_{15}$ ;
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ;
p est un entier de 3 à 8 ; et
m est un entier de 1 à 10 ;

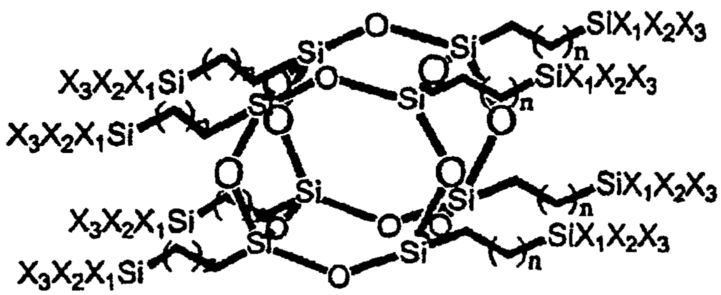

(2a)

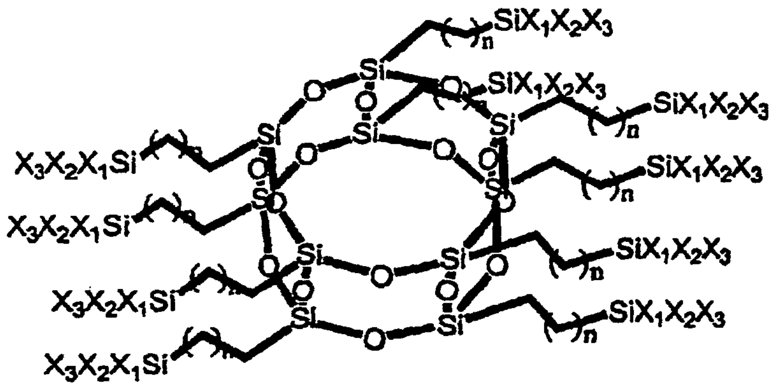

(2b)

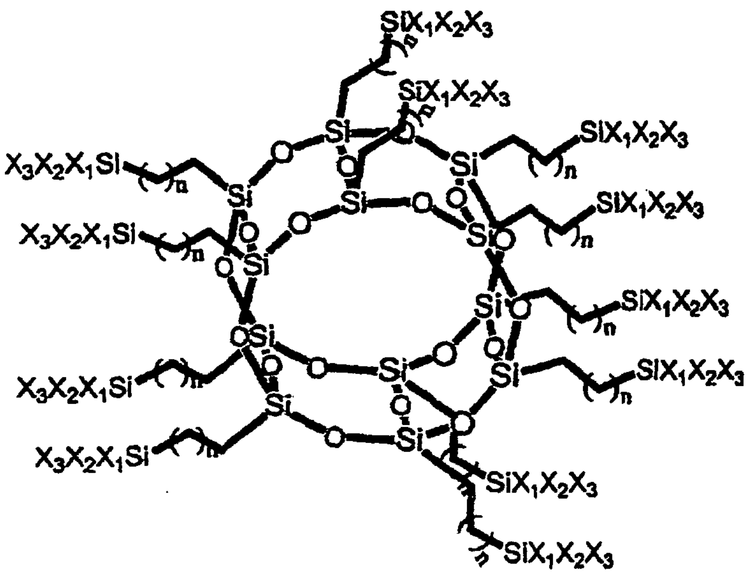

(2c)

dans les formules (2a) à (2c) ci-dessus,
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ; et
n est un entier de 1 à 12 ;

$$SiX_1X_2X_3X_4 \quad (3)$$

dans laquelle,
chacun des $X_1$, $X_2$, $X_3$ et $X_4$ est, indépendamment, un alcoxy en $C_1$ à $C_{10}$, ou un halogène ;

$$RSiX_1X_2X_3 \quad (4)$$

dans laquelle
R est H, un alkyle en $C_1$ à $C_3$, un cycloalkyle en $C_3$ à $C_{10}$, ou un aryle en $C_6$ à $C_{15}$ ; et
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène.

**4.** Résine à base de siloxane, dans laquelle la résine est préparée par l'hydrolyse et la polycondensation d'un composé de siloxane cyclique de formule (1), conjointement avec un composé de silane de formule (3) et/ou un composé de silane de formule (4), dans un solvant organique en présence d'un catalyseur et d'eau :

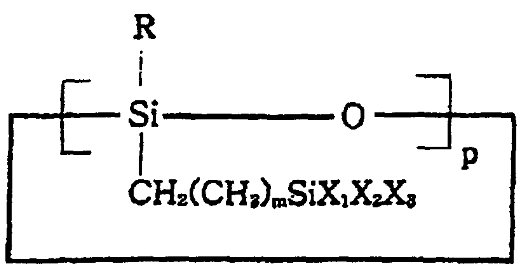

(1)

dans laquelle,
R est H, un alkyle en $C_1$ à $C_3$, un cycloalkyle en $C_3$ à $C_{10}$, ou un aryle en $C_6$ à $C_{15}$ ;
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ;
p est un entier de 3 à 8 ; et
m est un entier de 1 à 10 ;

$$SiX_1X_2X_3X_4 \qquad (3)$$

dans laquelle,
chacun des $X_1$, $X_2$, $X_3$ et $X_4$ est, indépendamment, un alcoxy en $C_1$ à $C_{10}$, ou un halogène ;

$$RSiX_1X_2X_3 \qquad (4)$$

dans laquelle
R est H, un alkyle en $C_1$ à $C_3$, un cycloalkyle en $C_3$ à $C_{10}$, ou un aryle en $C_6$ à $C_{15}$ ; et
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène.

**5.** Résine à base de siloxane, dans laquelle la résine est préparée par l'hydrolyse et la polycondensation d'un composé de siloxane en forme de cage de l'une quelconque des formules (2a) à (2c), conjointement avec un composé de silane de formule (3) et/ou un composé de silane de formule (4), dans un solvant organique en présence d'un catalyseur et d'eau :

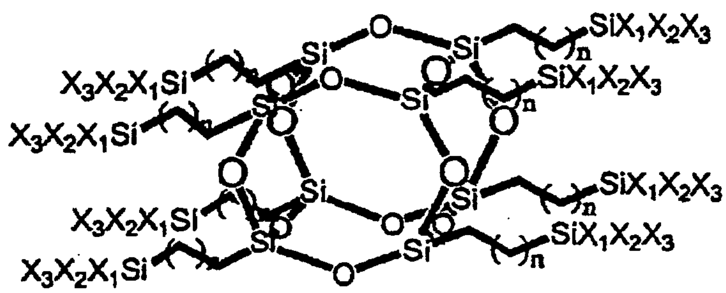

(2a)

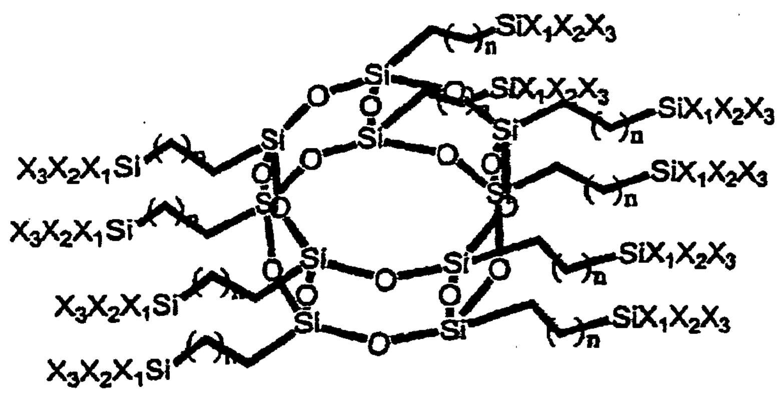

(2b)

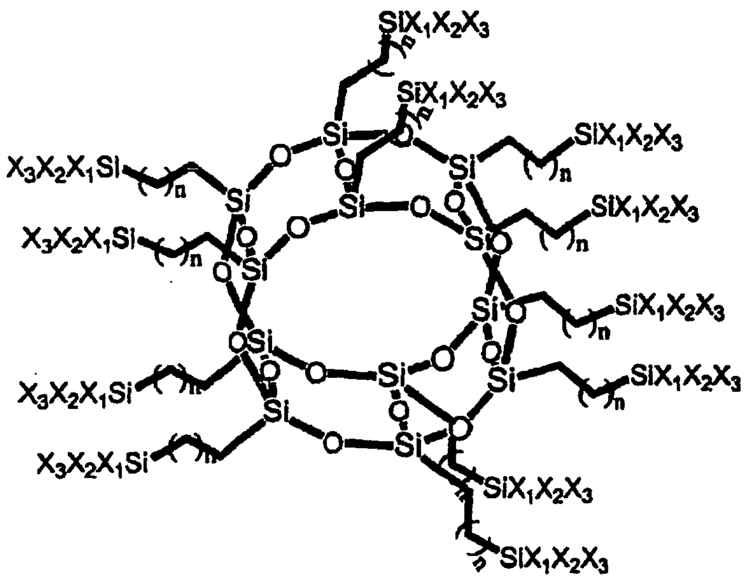

(2c)

dans les formules (2a) à (2c) ci-dessus,
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène ; et
n est un entier de 1 à 12 ;

$$SiX_1X_2X_3X_4 \quad (3)$$

dans laquelle,
chacun des $X_1$, $X_2$, $X_3$ et $X_4$ est, indépendamment, un alcoxy en $C_1$ à $C_{10}$, ou un halogène ;

$$RSiX_1X_2X_3 \quad (4)$$

dans laquelle
R est H, un alkyle en $C_1$ à $C_3$, un cycloalkyle en $C_3$ à $C_{10}$, ou un aryle en $C_6$ à $C_{15}$ ; et
chacun des $X_1$, $X_2$, et $X_3$ est, indépendamment, un alkyle en $C_1$ à $C_3$, un alcoxy en $C_1$ à $C_{10}$, ou un halogène, à la condition qu'au moins un soit un alcoxy ou un halogène.

6. Résine à base de siloxane selon l'une quelconque des revendications 1 à 5, dans laquelle le solvant organique est un solvant d'hydrocarbure aromatique, un solvant d'hydrocarbure aliphatique, un solvant à base de cétone, un solvant à base d'éther, un solvant à base d'acétate, un solvant à base d'alcool, un solvant à base de silicium, ou un mélange de ceux-ci.

7. Résine à base de siloxane selon l'une quelconque des revendications 1 à 6, dans laquelle le catalyseur est l'acide chlorhydrique, l'acide nitrique, l'acide benzène sulfonique, l'acide oxalique, l'acide formique, l'hydroxyde de potassium, l'hydroxyde de sodium, la triéthylamine, le bicarbonate de sodium, la pyridine, ou un mélange de ceux-ci.

8. Résine à base de siloxane selon l'une quelconque des revendications 1 à 7, dans laquelle 0,00001 à 10 moles de catalyseur sont ajoutées pour 1 mole de monomères devant être polycondensés.

9. Résine à base de siloxane selon l'une quelconque des revendications 1 à 8, dans laquelle 0,1 à 1000 moles d'eau sont ajoutées pour 1 mole de monomères devant être polycondensés.

10. Résine à base de siloxane selon l'une quelconque des revendications 1 à 9, dans laquelle l'hydrolyse et la polycondensation sont réalisées à une température de 0 à 200°C pendant 0,1 à 100 heures.

**11.** Résine à base de siloxane selon l'une quelconque des revendications 1 à 10, dans laquelle la teneur en Si-OR (dans laquelle, R est H, un alkyle en $C_1$ à $C_3$, un cycloalkyle en $C_3$ à $C_{10}$, ou un aryle en $C_6$ à $C_{15}$) de la résine est supérieure à 5 % en mole.

**12.** Résine à base de siloxane selon l'une quelconque des revendications 1 à 11, dans laquelle le poids moléculaire de la résine est entre 3 000 et 500 000.

**13.** Méthode de formation d'un film isolant entre des couches d'interconnexion dans des dispositifs à semi-conducteurs, dans laquelle la méthode comprend les étapes consistant à :

fournir une solution de résine en dissolvant la résine à base de siloxane selon l'une quelconque des revendications 1 à 12 dans un solvant organique ;
enduire une plaque de silicium avec la solution de résine ; et
durcir par voie thermique le film de revêtement résultant.

**14.** Méthode selon la revendication 13, dans laquelle le solvant organique est un solvant d'hydrocarbure aliphatique, un solvant d'hydrocarbure aromatique, un solvant à base de cétone, un solvant à base d'éther, un solvant à base d'acétate, un solvant à base d'alcool, un solvant à base d'amide, un solvant à base de silicium, ou un mélange de ceux-ci.

**15.** Méthode selon la revendication 13 ou 14, dans laquelle la teneur en résine à base de siloxane dans la solution de résine est de 0,1 à 80 % en poids.

**16.** Méthode selon l'une quelconque des revendications 13 à 15, dans laquelle la solution de résine comprend en outre un porogène, dans laquelle le rapport en poids de la résine à base de siloxane sur le porogène est entre 99:1 et 30:70.

**17.** Méthode selon la revendication 16, dans laquelle le porogène est la cyclodextrine, la polycaprolactone, ou un dérivé de celles-ci.

**18.** Méthode selon la revendication 16 ou 17, dans laquelle la teneur total en résine à base de siloxane et en porogène dans la solution de résine est de 0,1 à 80 % en poids.

**19.** Méthode selon l'une quelconque des revendications 13 à 18, dans laquelle le durcissement par voie thermique est réalisé à une température de 150 à 600°C pendant 1 à 150 minutes.